# EUROPÄISCHE PATENTSCHRIFT

(11) **EP 3 420 575 B1**
(45) Veröffentlichungstag und Bekanntmachung des Hinweises auf die Patenterteilung: **12.08.2020**
(21) Anmeldenummer: 17707280.8
(22) Anmeldetag: 24.02.2017
(51) Int. Cl.: H01H 85/08, H01H 85/045, H05K 1/02, H01H 85/046, H01H 85/175, H01H 85/153, H01H 85/11, H01H 85/10, H01H 85/041, H01H 85/02

(54) **ELEKTRISCHE SICHERUNGSVORRICHTUNG**
ELECTRIC FUSE DEVICE
DISPOSITIF ÉLECTRIQUE DE SÉCURITÉ

(30) Priorität: 24.02.2016 DE 102016103220; 31.05.2016 DE 102016109962; 31.05.2016 DE 102016109961; 20.06.2016 DE 202016103239 U
(43) Veröffentlichungstag der Anmeldung: 02.01.2019
(73) Patentinhaber: Lisa Dräxlmaier GmbH, 84137 Vilsbiburg (DE)
(72) Erfinder: STANGLMEIER, Rainer, 84051 Essenbach (DE); KERBER, Alfred, 84164 Moosthenning (DE); WORTBERG, Michael, 84405 Dorfen (DE); NIEDERMEIER, Benedikt, 84028 Landshut (DE); JAHN, Matthias, 84187 Moosberg (DE)
(86) Internationale Anmeldenummer: PCT/EP2017/054307
(87) Internationale Veröffentlichungsnummer: WO 2017/144654

(56) Entgegenhaltungen:
- DE-C1- 4 223 621
- US-A- 4 612 529
- US-A- 5 010 438
- US-A- 5 130 689

## Beschreibung

### Technisches Gebiet

Die vorliegende Erfindung betrifft eine elektrische Sicherungsvorrichtung zum Absichern einer elektrischen Verbindung sowie Herstellverfahren zum Herstellen einer elektrischen Sicherungsvorrichtung. Die Sicherungsvorrichtung ist insbesondere geeignet zum Einsatz in einem Kraftfahrzeug.

### Stand der Technik

Die vorliegende Erfindung wird im Folgenden hauptsächlich in Verbindung mit Bordnetzen in Kraftfahrzeugen erläutert. Es versteht sich, dass die vorliegende Erfindung aber in jeder Anwendung eingesetzt werden kann, in der elektrische Verbindungen abgesichert werden sollen.

Zur Absicherung von elektrischen Leitungen und Schaltungen vor Überlast werden in einem Kraftfahrzeug-Bordnetz in der Regel Schmelzsicherungen verwendet. Aus dem Stand der Technik sind hierfür insbesondere Schmelzsicherungen, bei denen ein Spalt zwischen zwei Leiterbahnen mit Hilfe eines aufgeschmolzenen Metallkörpers aus einem niedrigschmelzenden Metall überbrückt wird, bekannt. Eine derartige Sicherungsvorrichtung wird beispielsweise in der DE 10 2014 115 588 offenbart. Die Sicherungsvorrichtung besteht aus einem elektrisch isolierenden Träger, auf den zwei Leiterbahnen aufgebracht sind, die durch eine Materialverjüngung voneinander beabstandet sind. Aufgeschmolzenes Metall mit einem niedrigen Schmelzpunkt wird derart aufgebracht, dass die Materialverjüngung überbrückt wird.

Ähnliche Sicherungsvorrichtungen sind auch in der DE 10 2009 040 022 B3 oder der JP H09 161 635 A1 gezeigt. Ferner beschreibt GB 867 090 A Verbesserungen für Leiterplatten mit Sicherungen, wobei eine Leiterbahn als Sicherung fungiert. US 7 701 321 B2 offenbart eine Methode, um eine Anzahl von Leiterplatten miteinander zu verbinden. US 5 010 438 A zeigt ein steckbares Modul, um eine Einschwingspannung zu sperren. US 2 895 031 A beschreibt eine Sicherung mit einem niedrigen Widerstand.

US 5 130 689 A zeigt eine intermetallische Zeit-Temperatur-Integrationssicherung. DE 42 23 621 C1 offenbart eine Hochfrequenz-Schmelzsicherung mit einen Schmelzleiter, der eine erste Querschnittsfläche aufweist, die einen Hochfrequenzstrom führen kann. Die Schmelzsicherung umfasst weiterhin zwei elektrische Anschlüsse, die jeweils mit einem Ende des Schmelzleiters verbunden sind. US 4 612 529 A beschreibt eine Subminiatur-Sicherung mit zwei Klemmen, einem Grundteil, einem Sicherungs-Leiter sowie einem eine Einheit darstellendem Gehäuse.

Der Zinnkörper kann allerdings hinsichtlich seiner Größe, Form und Positionierung nur schwer reproduzierbar aufgebracht werden. Bereits kleinste Abweichungen beim Aufbringen des Zinns führen aber zu unterschiedlichsten Verhalten beim Aufschmelzen des Zinns, also beim Auslösen der Sicherung, sodass die Auslösecharakteristik der Sicherungseinrichtung großen Schwankungen unterliegt.

### Beschreibung der Erfindung

Es ist daher Aufgabe der Erfindung eine elektrische Sicherungsvorrichtung bereitzustellen, die eine definierte sowie eine zuverlässig reproduzierbare Auslösecharakteristik aufweist. Desweiteren betrifft die erfindungsgemäße Aufgabe ein Verfahren zur Herstellung einer solchen elektrischen Sicherungsvorrichtung.

Die Aufgabe wird durch den Gegenstand des unabhängigen Anspruchs gelöst. Vorteilhafte Weiterbildungen der Erfindung sind in den Unteransprüchen und in der Beschreibung angegeben.

Die erfindungsgemäße elektrische Sicherungsvorrichtung weist einen elektrisch isolierenden Träger, eine erste Leiterbahn und eine zweite Leiterbahn, die auf dem Träger aufgebracht und um einen Spalt voneinander beabstandet sind, und eine erste und eine zweite Durchgangsöffnung durch den Träger und durch die erste bzw. zweite Leiterbahn auf. Der Spalt wird, mittels eines, von einer Seite des Trägers durch die Durchgangsöffnungen gesteckten und auf der anderen Seite des Trägers aufgeschmolzenen, gebogenen Drahtes aus einem niedrigschmelzenden Metall überbrückt.

Der Draht ist vorteilhafterweise durchgängig aus einem niedrigschmelzenden Metall und um etwa 180° gebogen, sodass er einen Drahtbügel mit zwei annähernd parallel verlaufenden Drahtenden bildet. Auf diese Weise können die Drahtenden durch die Durchgangsöffnungen eines ebenen Trägers gesteckt werden. Zwischen den beiden eingesteckten Drahtenden verläuft der Drahtbügel beabstandet zu dem Spalt.

Im Gegensatz zu einem auf den Leiterbahnen aufgeschmolzenen Metallkörper hat die erfindungsgemäße Anordnung den Vorteil, dass das in Folge einer Überlast geschmolzene Metall nicht erst aus dem Spalt abfließen bzw. abgezogen werden muss. Dies ermöglicht ein verzugsfreies Unterbrechen bzw. Ansprechen der Sicherung. Erwärmt sich der gebogene Draht als Folge einer Überlast über seinen Schmelzpunkt hinaus beginnt der Draht zu schmelzen. Das geschmolzene Metall sammelt sich zu einem Tropfen, der aufgrund der Schwerkraft von dem Draht herabfällt. Die Beabstandung des Drahtes zum Spalt ist also größer als die Größe des Tropfens, beispielsweise zwischen 3 und 15 mm, sodass der Draht vollständig unterbrochen wird.

Durch den Materialverlust verringert sich der Querschnitt des Drahtes und die Stromdichte im Draht erhöht sich noch weiter. Dadurch steigt auch die Temperatur im Draht weiter an. Das Aufschmelzen des Drahtes und die Tropfenbildung beschleunigen sich. Dies setzt sich fort bis der Draht eine Unterbrechung durch Abtropfen und/oder sogar Verdampfen des niedrigschmelzenden Metalls aufweist. Dadurch ist die Leitungsunterbrechung eingetreten.

Weiterhin hat die Verwendung eines gebogenen Drahtes als Auslöseelement der Sicherung den Vorteil, dass sich die Kriterien für das Auslösen der Sicherung besonders genau einstellen lassen. Die Auslösecharakteristik der Sicherung ist wesentlich von der Ausgestaltung des Drahtes abhängig. Über die Dimensionierung des Drahtes kann folglich festgelegt werden, für welche Stromstärken die Sicherung ausgelegt ist und wie schnell die Sicherung auslöst. Ein Draht mit einem größeren Querschnitt besitzt eine höhere Wärmekapazität. Zum Erwärmen des Drahtes über seinen Schmelzpunkt hinaus ist daher mehr Energie notwendig. Das Auslösen der Sicherung bei kurzeitigen Lastspitzen kann somit träger reagierend eingestellt werden. Bei dauerhaften Überlasten kann die Sicherung jedoch durch den niedrigen Schmelzpunkt des Drahtes ausreichend schnell und sicher ansprechen. Entsprechend kann durch die Wahl eines Drahtes mit einer geringen Wärmekapazität eine Sicherung hergestellt werden, die bereits bei kürzeren Lastspitzen auslöst.

Desweiteren bietet die erfindungsgemäße Anordnung den Vorteil, dass die Sicherung sehr einfach und zuverlässig herstellbar ist. Die definierte Dimensionierung des Drahtes erlaubt es, eine große Anzahl an Drähten mit genau gleicher Auslösecharakteristik herzustellen. Auch die Position des Drahtes ist durch die Anordnung in den Durchgangsöffnungen vorgegeben. Herstellungsbedingte Schwankungen in Form und Position des niedrigschmelzenden Metallkörpers, die die Auslösecharakteristik der Sicherungsvorrichtung beeinflussen, werden somit auf ein Minimum reduziert.

Unter einem Draht ist jedoch nicht nur ein längliches Stück Metall mit kreisförmiger Querschnittsfläche zu verstehen, vielmehr kann die Querschnittsfläche beliebige Formen annehmen, wie beispielsweise oval, rechteckig, quadratisch, etc. Die Dicke des Drahtes ist von dem Querschnitt der abzusichernden Leitungen abhängig. Als vorteilhaft hat sich hierbei ein Draht mit einem kreisförmigen Querschnitt und einer Querschnittsfläche, die deutlich kleiner als die Querschnittsfläche der abzusichernden Leitungen ist, herausgestellt. Insbesondere beträgt die Querschnittsfläche des Drahtes 64 % bis 87 % der Querschnittsfläche der abzusichernden Leitung. Der Durchmesser des Drahtes liegt typischerweise zwischen 0,5 mm und 1,5 mm.

Der elektrisch isolierende Träger ist insbesondere ein plattenförmiger Träger und kann zusammen mit den Leiterbahnen eine Leiterplatte bilden, auf der weitere elektronische Bauelemente angeordnet sein können. Um die Auslösecharakteristik der Sicherungsvorrichtung nicht zu beeinflussen, besteht der Träger bevorzugt aus einem schlecht wärmeleitfähigen Material. Dies verhindert, dass die im Draht und/oder den Leiterbahnen erzeugte Wärme in den Träger abfließen kann, was ein Auslösen der Sicherungsvorrichtung verzögern würde. Als solches Material eignet sich beispielsweise ein herkömmliches Leiterplattenmaterial, wie FR4. Da FR4 bis ca. 300°C nutzbar ist, lässt es sich aufgrund der niedrigen Schmelztemperatur des gebogenen Drahtes verwenden. Denkbar wäre auch ein Träger aus Keramik. Da Keramik besonders temperaturbeständig ist, kann auch ein gebogener Draht mit einen Schmelzpunkt von über 250°C verwendet werden.

Die erste Leiterbahn und die zweite Leiterbahn können in Bezug auf ihr Material, ihre Dicke und/oder ihre Breite gleich oder unterschiedlich ausgestaltet sein. Die erste und zweite Leiterbahn sind aus einem Metall, das einen höheren Schmelzpunkt als der gebogene Draht aufweist. Hierfür eignet sich insbesondere Kupfer. Die Dicke der Leiterbahnen richtet sich danach, für welchen Leitungsquerschnitt eine Sicherung ausgelegt sein soll. Dabei hat sich als vorteilhaft erwiesen, wenn die Leiterbahnen eine Querschnittsfläche aufweisen, die etwa 18 % bis 40 % der Querschnittsfläche der abzusichernden Leitung entspricht. Insbesondere haben die Leiterbahnen eine Dicke zwischen 50 µm und 500 µm Mikrometer. Die erste und zweite Leiterbahn sind durch einen Spalt mit einer Spaltbreite zwischen zwei und drei Millimetern voneinander beabstandet.

In einer bevorzugten Ausführungsform ist der Draht von der Seite des Trägers, die den Leiterbahnen gegenüberliegt, durch die Durchgangsöffnungen gesteckt. Der Draht wird dann durch Aufschmelzen, insbesondere Verlöten, direkt mit den Leiterbahnen stoffschlüssig verbunden. Das erlaubt eine vereinfachte und automatisierte Fertigung der Sicherungsvorrichtung mit guter elektrischer Leitfähigkeit zwischen Draht und Leiterbahnen.

Eine weitere vorteilhafte Ausgestaltung der Erfindung sieht vor, dass der Draht von der Seite des Trägers durch die Durchgangsöffnungen gesteckt wird, auf der auch die Leiterbahnen aufgebracht sind. Für eine optimale Kontaktierung der Leiterbahnen mit dem gebogenen Draht ist weiterhin vorgesehen, dass der Träger in den Durchgangsöffnungen eine elektrisch leitfähige Beschichtung aufweist, die mit der ersten bzw. zweiten Leiterbahn elektrisch leitend verbunden ist. Dadurch erstrecken sich die Leiterbahnen durch den Träger bis auf die Rückseite des Trägers, sodass durch das Aufschmelzen des Drahtes auf der den Leiterbahnen gegenüberliegenden Seite des Trägers und in den Durchgangsöffnungen eine Kontaktierung mit den Leiterbahnen ermöglicht wird.

Um eine zuverlässige Kontaktierung des Drahtes mit den Leiterbahnen weiter zu unterstützen, können auf der den Leiterbahnen gegenüberliegenden Seite des Trägers angrenzend an die Durchgangsöffnungen und mit der Beschichtung elektrisch leitend verbunden, Lötflächen auf dem Träger aufgebracht sein. Beim Aufschmelzen des Drahtes zum Verbinden mit den Leiterbahnen verteilt sich das niedrigschmelzende Material über die Lötflächen und stellt dadurch eine größere Kontaktfläche zwischen Draht und Leiterbahnen her. Neben einer guten Kontaktierung wird durch die größere Kontaktfläche auch eine mechanisch stabile Verbindung zwischen Draht und Leiterbahnen geschaffen.

In einer besonders vorteilhaften Ausführungsform weist der Träger auf der Vorderseite und auf der Rückseite im Wesentlichen deckungsgleich aufgebrachte erste und zweite Leiterbahnen auf, die über eine elektrisch leitfähige Beschichtung in den Durchgangsöffnungen miteinander verbunden sind. Diese Anordnung gewährleistet, dass sich der Träger von beiden Seiten gleichmäßig erwärmt und sich der Träger nicht in Folge einer ungleichmäßigen Erwärmung verbiegt. Der von einer Seite durch den Träger gesteckte Draht wird dann auf der anderen Seite durch Aufschmelzen, insbesondere Verlöten, direkt mit den Leiterbahnen stoffschlüssig verbunden.

Vorteilhafterweise variiert die Querschnittsfläche des Drahtes entlang seiner Länge. Insbesondere kann durch eine lokale Verringerung der Querschnittsfläche eine Sollbruchstelle, beispielsweise mittig im Draht, beim Aufschmelzen des Drahtes erreicht werden. Die Auslösecharakteristik lässt sich somit auf einfache und vorteilhafte Weise genau an die Bedürfnisse anpassen. In der Regel ist die Dicke des Drahtes abhängig von den abzusichernden elektrischen Leitern und Schaltungen. Um eine stabile Verbindung des Drahtes mit dem elektrischen Kontakt herstellen zu können, muss die Durchgangsöffnung an die Querschnittsform und Querschnittsgröße des gebogenen Drahtes angepasst werden. Durch die Schaffung einer Sollbruchstelle müssen die Durchgangsöffnungen nicht mehr an die Ausgestaltung des gebogenen Drahtes angepasst werden, sondern der gebogene Draht wird unter Berücksichtigung der Auslösekriterien an den Träger angepasst. Derselbe Träger kann somit für Sicherungen mit verschiedenen Auslösekriterien verwendet werden.

Der Draht ist bevorzugt ein Massivdraht. Bei dem Massivdraht handelt es sich um ein längliches Metallstück aus durchgängig niedrigschmelzendem Metall. Dies ist einfach und kostengünstig herzustellen. Gleichzeitig ist der Draht aber auch stabil und widerstandsfähig gegen Beschädigungen und Korrosion. Auch das Kontaktieren des Drahtes mit den Leiterbahnen bzw. den Lötflächen wird durch das Verwenden eines solchen Massivdrahtes vereinfacht, da der Draht nach dem Einstecken in die Durchgangsöffnungen durch Aufschmelzen direkt mit den Leiterbahnen bzw. den Lötflächen verbunden wird.

Erfindungsgemäß ist das niedrigschmelzende Metall des Drahtes Zinn oder eine Zinnlegierung. Zinn zeichnet sich besonders durch seinen niedrigen Schmelzpunkt von 231°C aus. Um die Härte und Zugfestigkeit des Drahtes zu verbessern und/oder den Schmelzpunkt des Drahtes an die Auslösecharakteristik anzupassen kann der Draht auch aus einer Zinnlegierung hergestellt sein. Besonders geeignet sind hierfür Zinnlegierungen mit einem überwiegenden Gewichtsanteil von Zinn mit Beimischungen von Kupfer, Blei, Silber, Bismut und/oder Antimon.

Die Auslösecharakteristik der Sicherung kann auch durch die Gestaltung der Leiterbahnen beeinflusst werden. So ist die Auslösekennlinie der Sicherung von der Länge der Leiterbahnen abhängig. In einer vorteilhaften Ausgestaltung verläuft daher die erste und/oder zweite Leiterbahn mäanderförmig. In einer Überlastsituation steigt nicht nur die Temperatur im Draht, sondern auch in den Leiterbahnen an. Dabei fließt Wärme sowohl in die Anschlüsse, die die Leiterbahnen mit den Leitungen verbindet, als auch in die Leitungen ab. Insbesondere bei kurzen Leiterbahnen verlangsamt dies den Temperaturanstieg in der Leiterbahn. Bei langen Leiterbahnen hat dieser Effekt jedoch kaum Einfluss auf den Temperaturanstieg in den Leiterbahnen. Lange Leiterbahnen erwärmen sich deshalb schneller. Durch lange Leiterbahnen wird somit auch ein schnelleres und zuverlässiges Aufschmelzen des Drahtes unterstützt, da sich zwischen den Leiterbahnen und dem Draht ein thermisches Gleichgewicht schneller einstellt, das verhindert, dass die Wärme vom Draht in die Leiterbahnen abfließt. Durch die Anordnung der Leiterbahn in einer Mäanderform kann der Träger trotz langer Leiterbahnen möglichst kompakt gehalten werden. Die Länge der Leiterbahn entspricht etwa dem 20 bis 40-fachen des Kehrwerts der Wurzel aus der Steckerbreite. Mit Steckerbreite ist hierbei die Breite der Anschlussfläche zum Verbinden der Leitungen mit der Sicherung gemeint. Für Sicherungen im Automobilbereich ist die Steckerbreite für eine MINI-Sicherung 2,8 mm, für eine ATO-Sicherung 5,2 mm und für eine MAXI-Sicherung 8 mm.

Weiterhin kann auch eine Querschnittsfläche der ersten und/oder zweiten Leiterbahn entlang seiner Länge variieren. Vorteilhaft ist es, wenn die Querschnittsfläche zu den Durchgangsöffnungen hin abnimmt. Durch die abnehmende Querschnittsfläche steigt die Stromdichte in der Leiterbahn an und beschleunigt somit einen Temperaturanstieg bei Überstrom in der Nähe der Durchgangsöffnungen. Das sich schneller einstellende thermische Gleichgewicht zwischen Draht und Leiterbahn vermindert wieder die Wärmeableitung vom Draht in die Leiterbahnen. Gleichzeitig wird durch die größere Querschnittsfläche der Leiterbahnen in der Nähe der Anschlüsse die Wärmekapazität der Leiterbahnen in diesem Bereich erhöht, sodass ein Abfließen der Wärme in die Anschlüsse und die abzusichernden Leitungen vermindert wird, wodurch die Leitungen beschädigt werden könnten.

Außerdem kann zur Aufnahme der Durchgangsöffnungen die Querschnittsfläche der Leiterbahnen in diesem Bereich vergrößert werden. In der Ausführungsform, in der der Draht von der den Leiterbahnen gegenüberliegenden Seite des Trägers durch die Durchgangsöffnungen gesteckt ist bzw. in der Ausführungsform, in der auf beiden Seiten des Trägers Leiterbahnen aufgebracht sind, können die Leiterbahnen außerdem Flächen zum Verlöten des Drahtes mit den Leiterbahnen aufweisen.

Besonders vorteilhaft ist es, wenn die erste und zweite Leiterbahn symmetrisch zueinander ausgebildet sind. Durch die symmetrische Ausbildung der Leiterbahnen können die Effekte, die durch die mäanderförmig aufgebrachten Leiterbahnen und durch die Leiterbahnen mit abnehmender Querschnittsfläche erzielt werden, noch verstärkt werden, da insbesondere das Abfließen der Wärme vom Draht in die Leiterbahnen auf beiden Seiten vermindert wird.

Bevorzugt weist der Träger einen Durchbruch im Bereich des Spalts auf, sodass im Auslösefall das geschmolzene Metall des gebogenen Drahtes durch den Durchbruch abfließen kann. Der Durchbruch kann als Bohrung oder durchgängiges Loch ausgebildet sein. Das Abfließen des niedrigschmelzenden Metalls durch den Durchbruch verhindert, dass sich das vom Drahtbügel herabtropfende niedrigschmelzende Metall beim Auslösen der Sicherung auf dem Träger ansammeln kann und einen Kurzschluss zwischen den Kontaktstellen verursacht. Dadurch wird ein sicheres Auslösen der Sicherung unabhängig von der räumlichen Orientierung der verbauten Sicherung unterstützt.

Besonders vorteilhaft ist es, wenn der Durchbruch im Träger mit einer Sollbruchstelle des gebogenen Drahtes kombiniert wird. Da der Bereich, an dem das niedrigschmelzende Metall vom Drahtbügel bevorzugt herabtropft, bekannt ist, kann der Durchbruch direkt unter der Sollbruchstelle angeordnet werden und das niedrigschmelzende Material zuverlässig durch den Durchbruch abfließen.

In einer vorteilhaften Weiterbildung weist der Träger mehrere erste Durchgangsöffnungen und eine gleiche Anzahl zweiter Durchgangsöffnungen durch den Träger und die erste bzw. zweite Leiterbahn auf. Der Spalt wird dann durch mehr als einen gebogenen Draht überbrückt. Durch die parallele Anordnung der einzelnen Sicherungselemente verringert sich die Stromstärke in den einzelnen Drähten. Die Drähte können mit einem geringeren Querschnitt ausgestattet sein, wodurch sich das Aufschmelzen der Drähte und damit die Auslösezeit der Sicherungsvorrichtung verkürzt. Besonders vorteilhaft kann eine solche Sicherung zur Absicherung von Schaltungen, in denen sehr hohe Ströme fließen, eingesetzt werden. Der Draht einer solchen Sicherung müsste entsprechend dick ausgebildet sein, um den hohen Strömen standhalten zu können. Das Aufschmelzen des Drahtes bei Überstrom würde aber entsprechend lange dauern. Durch die Parallelschaltung mehrerer Drähte können die einzelnen Drähte dünner ausgebildet sein und das Aufschmelzen erfolgt ausreichend schnell.

Um das Auslösen der Sicherungsvorrichtung hingegen zu verzögern, kann sich auf mindestens einer der beiden Leiterbahnen in der Nähe des gebogenen Drahtes, den Spalt nicht überbrückend, ein Metallkörper aus dem gleichen niedrigschmelzenden Metall befinden. Der den Spalt nicht überbrückende Metallkörper hat den Vorteil, dass er als Wärmedepot für den gebogenen Draht dient. Der gebogene Draht, der elektrisch in Reihe mit den Leiterbahnen geschaltet ist, wird bei kurzzeitigen Lastspitzen durch den Stromfluss erwärmt. Die im Draht erzeugte Wärme kann über die gemeinsam kontaktierte Leiterbahn zu dem Metallkörper abfließen. Bei kurzfristigen Lastspitzen kann dadurch die Temperatur im Draht etwas gesenkt und das Aufschmelzen des Drahtes verzögert werden. Bei dauerhaften Überlasten hat der Metallkörper praktisch keinen Einfluss auf den Auslösezeitpunkt. Da sich die Sicherungsvorrichtung in diesem Fall im thermischen Gleichgewicht befindet, schmelzen sowohl der Draht als auch der Metallkörper.

Weiterhin kann vorgesehen sein, dass statt zusätzlicher Metallkörper auf den Leiterbahnen, die Lötflächen zur Aufnahme einer größeren Menge niedrigschmelzenden Materials, als zur mechanisch und elektrisch stabilen Verbindung des Drahtes mit den Leiterbahnen nötig ist, ausgebildet sind. Dadurch kann gleichzeitig der Draht mit den Leiterbahnen verbunden und zusätzliche Metallkörper erstellt werden. Die dafür benötigte Materialmenge kann bereits bei der Dimensionierung des Drahtes berücksichtigt werden.

In einer vorteilhaften Ausgestaltung sind eine erste Leiterbahn und mehrere zweite Leiterbahnen auf dem Träger aufgebracht und mehrere Spalte zwischen der ersten und einer jeweiligen zweiten Leiterbahn werden durch jeweils einen gebogenen Draht überbrückt. Diese Anordnung, die auch als "Multifuse" bezeichnet wird, ermöglicht einen besonders platzsparenden Aufbau. Je nach der abzusichernden Leitung kann die jeweilige zweite Leiterbahn unterschiedlich ausgebildet sein. So können die verschiedenen zweiten Leiterbahnen z.B. unterschiedliche Breite, Dicke, Länge und/oder Form aufweisen. Die einzelnen gebogenen Drähte müssen ebenfalls nicht gleich dimensioniert sein. Durch das Durchstecken der gebogenen Drähte durch Durchgangsöffnungen können die einzelnen Drähte in ihrer Ausgestaltung individuell an die abzusichernden elektrischen Leiter und Schaltungen angepasst werden.

Mit anderen Worten ist eine elektrische Sicherungsvorrichtung zum Absichern einer elektrischen Verbindung vorgesehen. Die Sicherungsvorrichtung weist einen elektrisch isolierenden Sicherungsträger auf, also einen Träger, der keinen elektrischen Strom leitet. Auf dem Sicherungsträger sind ein erster elektrischer Kontakt und ein zweiter elektrischer Kontakt angeordnet, wobei der zweite elektrische Kontakt von dem ersten elektrischen Kontakt elektrisch isoliert ist. Die elektrischen Kontakte sind als zwei voneinander separierte Leiterbahnen ausgebildet. Ferner ist eine Anzahl, also ein einzelnes oder mehrere, von Sicherungselementen vorgesehen, welche elektrisch mit dem ersten elektrischen Kontakt und dem zweiten elektrischen Kontakt gekoppelt sind. Der vorstehend beschriebene Draht wird hier als Sicherungselement verwendet. In einer vorteilhaften Weiterbildung weisen die Sicherungselemente ein elektrisch leitendes Sicherungsmaterial mit einer vorgegebenen Strombelastbarkeit und ein Schmelzmittel in Kontakt mit dem Sicherungsmaterial auf, wobei das Schmelzmittel einen niedrigeren Schmelzpunkt aufweist, als das Sicherungsmaterial.

Ferner ist ein Herstellverfahren zum Herstellen einer elektrischen Sicherungsvorrichtung vorgesehen. Das Verfahren weist die folgenden Schritte auf: Bereitstellen eines elektrisch isolierenden Sicherungsträgers, Anordnen eines ersten elektrischen Kontakts auf dem Sicherungsträger und Anordnen eines zweiten elektrischen Kontakts auf dem Sicherungsträger elektrisch isoliert von dem ersten elektrischen Kontakt. Ferner ist vorgesehen ein elektrisches Koppeln einer Anzahl von Sicherungselementen mit dem ersten elektrischen Kontakt und dem zweiten elektrischen Kontakt.

In einer speziellen Ausführungsform weisen die Sicherungselemente ein elektrisch leitendes Sicherungsmaterial mit einer vorgegebenen Strombelastbarkeit und ein Schmelzmittel in Kontakt mit dem Sicherungsmaterial auf, wobei das Schmelzmittel einen niedrigeren Schmelzpunkt aufweist, als das Sicherungsmaterial.

Der Sicherungsträger kann jedes beliebige Material sein, das elektrisch nicht leitet, also ein elektrischer Isolator ist. Beispielsweise kann der Sicherungsträger herkömmliche Leiterplattenmaterialien, wie z.B. ein papierbasiertes FR2 oder FR3 aufweisen. Möglich ist auch die Verwendung von FR4, welches ein Verbundwerkstoff aus Epoxidharz und Glasfasergewebe ist, oder FR5. Weitere mögliche Materialien sind z.B. Keramik-Materialien oder Teflon. Die Auswahl des jeweiligen Materials kann dabei insbesondere in Abhängigkeit des benötigten Temperaturbereichs erfolgen.

Die zwei elektrischen Kontakte können auf dem Sicherungsträger z.B. als Leiterbahnen oder Lötpunkte bzw. Lötkontakte ausgebildet sein. Zwischen den zwei elektrischen Kontakten ist dabei eine Lücke vorhanden, die einen elektrischen Strompfad unterbricht. Es versteht sich, dass die elektrischen Kontakte an ihren den Sicherungselementen gegenüberliegenden Enden z.B. mit einem Steckkontakt oder dergleichen gekoppelt sein können. Sie bilden also die Zuleitungen zu den eigentlichen Sicherungselementen. Es versteht sich, dass die Sicherungsvorrichtung eine beliebige Anzahl von Sicherungselementen aufweisen kann, insbesondere kann sie z.B. nur ein Sicherungselement aufweisen. Sind mehrere Sicherungselemente vorgesehen, sind diese regelmäßig elektrisch parallel geschaltet. Ferner sind mehrere völlig voneinander unabhängige Sicherungen auf einer Platine mit dieser Technologie ebenfalls möglich.

Im Gegensatz zu herkömmlichen Sicherungen bestehen die Sicherungselemente selbst nicht nur aus einem Sicherungsmaterial, welches bei einer elektrischen Überlastung aufschmilzt. Vielmehr steht das Sicherungsmaterial in Kontakt mit einem Schmelzmittel.

Als Sicherungsmaterial kann jedes elektrisch leitende Material genutzt werden, dass eine für die jeweilige Anwendung vorgegebene Strombelastbarkeit aufweist. Unter der Strombelastbarkeit ist dabei zu verstehen, wie groß der elektrische Strom sein darf, der über das Sicherungselemente fließt, bevor dieses auslöst, also z.B. schmilzt. Die Strombelastbarkeit bestimmt sich dabei insbesondere basierend auf dem genutzten Material, also z.B. dessen spezifischen Wiederstand, dessen geometrischen Dimensionen und dessen Schmelzpunkt. Ferner muss das Sicherungsmaterial die für die jeweilige Anwendung gewünschte Auslösecharakteristik aufweisen. Das Sicherungsmaterial muss also bei einer elektrischen Überlastung, z.B. einem überhöhten Strom, innerhalb der gewünschten Auslösezeit schmelzen und damit den Stromfluss unterbrechen.

Wird das Sicherungsmaterial nicht gekapselt, steht es mit der Umgebungsluft und dem darin enthaltenen Sauerstoff in Kontakt. Durch den Kontakt mit dem Sauerstoff oxidiert das Sicherungsmaterial. Auf der Oberfläche des Sicherungsmaterials bildet sich folglich eine Oxidschicht.

Eine solche Oxidschicht besitzt allerdings üblicherweise andere physikalische Eigenschaften, als das Sicherungsmaterial selbst. Insbesondere kann die Oxidschicht z.B. eine höhere Schmelztemperatur aufweisen, als das Sicherungsmaterial. Durch die höhere Schmelztemperatur kann aber ein Auslösen der Sicherung verzögert werden. Beispielsweise kann eine äußere Oxidschicht wie eine Art Schlauch um bereits verflüssigtes Sicherungsmaterial wirken. Durch diesen Schlauch wird das verflüssigte Sicherungsmaterial in Form gehalten und leitet weiterhin elektrischen Strom.

Das Schmelzmittel kann z.B. ein Flussmittel sein und dient dazu, die Oxidschicht zu zersetzen bzw. zu zerstören, wenn sich das Sicherungsmaterial und die Oxidschicht erhitzen. Alternativ kann das Schmelzmittel auch ein entstehen einer Oxidschicht verzögern, verringern oder verhindern.

Mit Hilfe des Schmelzmittels kann also sichergestellt werden, dass sich die Auslösecharakteristik der Sicherungselemente nicht verändert bzw. dass diese konstant erhalten bleibt. Als Schmelzmittel kann jedes Material genutzt werden, dessen Schmelzpunkt unter dem des Sicherungsmaterials liegt. Beispielsweise kann jedes bekannte Flussmittel eingesetzt werden, welches die Eigenschaft aufweist, die Oxidschicht zu zersetzen. Insbesondere können aber sog. No-Clean Flussmittel eingesetzt werden, bei denen nach dem Aufbringen bzw. Verlöten keine Reinigung der Schaltung notwendig ist.

Weitere, besonders vorteilhafte Ausgestaltungen und Weiterbildungen der Erfindung ergeben sich aus den abhängigen Ansprüchen sowie der nachfolgenden Beschreibung, wobei die Merkmale verschiedener Ausführungsbeispiele zu neuen Ausführungsbeispielen kombiniert werden können. Insbesondere können die unabhängigen Ansprüche einer Anspruchskategorie auch analog zu den abhängigen Ansprüchen einer anderen Anspruchskategorie weitergebildet sein.

In einer Ausführungsform kann die elektrische Sicherungsvorrichtung brückenartige Sicherungselemente aufweisen, die jeweils einen frei schwebenden Sicherungsabschnitt und an den Enden dieses Sicherungsabschnitts jeweils ein Lager aufweisen. Eines der Lager ist mit dem ersten elektrischen Kontakt und eines der Lager mit dem zweiten elektrischen Kontakt elektrisch gekoppelt, z.B. verlötet oder verklebt. Im Gegensatz zu einem auf dem Träger aufgeschmolzenen Zinnkörper hat die erfindungsgemäße Anordnung den Vorteil, dass geschmolzenes Material der Sicherungselemente nicht erst abfließen bzw. abgezogen werden muss. Bei den brückenartigen Sicherungselementen erfolgt daher ein verzugsfreies Unterbrechen bzw. Ansprechen der Sicherung. Erwärmen sich die Sicherungselemente über ihren Schmelzpunkt hinaus, beginnen sie zu schmelzen. Das geschmolzene Metall sammelt sich zu einem Tropfen, der aufgrund der Schwerkraft von den Sicherungselementen herabfällt. Durch den Materialverlust verringert sich der Querschnitt der Sicherungselemente und die Stromdichte in den Sicherungselementen erhöht sich noch weiter. Dadurch steigt auch die Temperatur in den Sicherungselementen weiter an. Das Aufschmelzen der Sicherungselemente und die Tropfenbildung beschleunigen sich. Dies setzt sich fort bis die Sicherungselemente eine Unterbrechung aufweisen und die Leitung damit unterbrochen ist.

Der Abstand zwischen den elektrischen Kontakten ist dabei so zu wählen, dass er durch das heruntertropfende Material der Sicherungselemente nicht überbrückt wird. Der Sicherungsträger kann auch hochkant verbaut werden, so dass heruntertropfendes Material parallel zu dem Sicherungsträger heruntertropft und nicht auf diesem landet.

In einer Ausführungsform kann die elektrische Sicherungsvorrichtung ein Isolationsmaterial aufweisen, das mindestens einen der elektrischen Kontakte zumindest teilweise bedeckt. Das Isolationsmaterial ist ein elektrisch nicht-leitendes Material. Es kann z.B. einen der elektrischen Kontakte dort bedecken, wo das Sicherungsmaterial auf den Sicherungsträger tropfen kann, wenn es sich verflüssigt. Damit verhindert es eine elektrisch leitfähige Brücke zwischen den zwei elektrischen Kontakten. Das Isolationsmaterial kann dazu lediglich einen der elektrischen Kontakte oder beide elektrischen Kontakte bedecken. Das Isolationsmaterial kann insbesondere auch den Raum auf dem Sicherungsträger zwischen den zwei elektrischen Kontakten bedecken. Als Isolationsmaterial kommt dabei jedes Material in Frage, welches den Temperaturen des geschmolzenen Sicherungsmaterials standhalten kann. Beispielsweise kann das Isolationsmaterial ein Harz, ein Kunststoff oder dergleichen sein.

In einer Ausführungsform kann der Sicherungsträger an jedem der elektrischen Kontakte für jedes der Sicherungselemente eine Durchgangsöffnung aufweisen. Ferner kann jeweils ein Ende eines entsprechenden der Sicherungselemente durch die entsprechende Durchgangsöffnung geführt sein und mit dem jeweiligen elektrischen Kontakt verlötet sein. Die Durchgangsöffnungen können z.B. als Durchkontaktierungen in dem Trägerelement ausgeführt sein. Dabei kann der jeweilige elektrische Kontakt entweder auf der dem jeweiligen Sicherungselement gegenüberliegenden Seite des Sicherungsträgers oder auf der Seite des jeweiligen Sicherungselements angeordnet sein. Eine gemischte Anordnung ist ebenfalls möglich, also ein Kontakt auf der Seite des jeweiligen Sicherungselements und einer auf der gegenüberliegenden Seite.

Die Durchkontaktierungen können eine elektrisch Leitende Beschichtung aufweisen. Sie können also Strom von einer Seite des Sicherungsträgers zur anderen Seite leiten und umgekehrt. Solche Durchkontaktierungen können auch Vias genannt werden. Ferner können die Durchkontaktierungen Lötflächen auf der Oberfläche einer oder beider Seiten des Sicherungsträgers zum verlöten des jeweiligen Sicherungselements aufweisen.

Die Sicherungselemente können so sehr einfach mit den elektrischen Kontakten verbunden, z.B. eben verlötet oder verklebt werden.

In einer Ausführungsform kann das Schmelzmittel auf der Außenseite des Sicherungsmaterials aufgebracht sein. Das Schmelzmittel kann also z.B. auf das Sicherungsmaterial aufgestrichen, aufgesprüht oder aufgedampft werden. Alternativ kann das Sicherungsmaterial in ein Bad aus Schmelzmittel getaucht werden, bevor es auf dem Sicherungsträger befestigt wird. Ein solches Sicherungselement ist sehr einfach herzustellen und kann mit jeder beliebigen Form und Größe hergestellt werden.

In einer Ausführungsform kann das Schmelzmittel im Inneren des Sicherungsmaterials angeordnet sein. Das Sicherungsmaterial kann also z.B. eine Seele aus Schmelzmittel aufweisen. Beispielsweise kann das Sicherungsmaterial ein Draht sein, der bereits bei seiner Herstellung mit der Seele aus Schmelzmittel versehen wird. Das Sicherungsmaterial kann aber z.B. auch aus zwei miteinander verpressten Platten bestehen, in deren Zwischenraum das Schmelzmittel angeordnet ist. Werden die Ränder der Platten verpresst, kann das Schmelzmittel nicht aus dem Zwischenraum zwischen den Platten entweichen.

Selbstverständlich kann das Schmelzmittel auch sowohl im Inneren als auf der Außenseite des Sicherungselements angeordnet sein.

Mit Zinn oder einer Zinnlegierung, als Sicherungsmaterial können Sicherungselemente bereitgestellt werden, die eine gewisse Trägheit aufweisen. Solche trägen Sicherungselemente lösen also nicht bereits bei kurzen Stromspitzen aus, sondern lösen erst bei länger andauernden Überlast-Situationen aus. So kann vermieden werden, dass ein Sicherungselement bei kurzen Stromspitzen bereits zerstört wird, die z.B. für die abgesicherten Kabel und Steckverbinder noch keine Gefahr darstellen. Gleichzeitig wird sichergestellt, dass das Sicherungselement bei einer anhaltenden Überlastung schmilzt, also auslöst, und den Stromfluss unterbricht. Unter einem Weichlotmaterial ist Lotmaterial zu verstehen, dessen Schmelzpunkt weniger als 450°C beträgt. Der Schmelzpunkt kann z.B. bei weniger als 250°C, insbesondere auch weniger als 200°C, liegen.

In einer Ausführungsform können die Sicherungselemente als Draht, erfindungsgemäß aus Zinn oder einer Zinnlegierung, mit einer Seele aus Schmelzmittel ausgebildet sein. Ferner können die Enden der Sicherungselemente auf der dem jeweiligen Sicherungselement gegenüberliegenden Seite des Sicherungsträgers mit dem jeweiligen elektrischen Kontakt verlötet bzw. verklebt sein. Die Sicherungselemente können also z.B. aus herkömmlichem, handelsüblichem Lötzinn ausgebildet sein, welches üblicherweise bereits eine Seele aus Schmelzmittel, z.B. Flussmittel, aufweist. Wird nun das Sicherungsmaterial, also das Zinn bzw. die Zinnlegierung, durch eine elektrische Überlast aufgeschmolzen aber noch durch die Oxidschicht in Form gehalten, kommt das Schmelzmittel durch das aufgeschmolzene Sicherungsmaterial hindurch in Kontakt mit der Oxidschicht und kann diese zerstören. Auf Grund seines niedrigeren Schmelzpunktes kann das Schmelzmittel beim Schmelzen des Sicherungsmaterials auch bereits sieden, und z.B. Blasen werfen. Diese unterstützen die Zerstörung der Oxidschicht mechanisch durch den Druck, den sie erzeugen.

Ist der Schmelzpunkt des Schmelzmittels ausreichend weit von dem Schmelzpunkt des Sicherungsmaterials entfernt, kann das Schmelzmittel bereits seinen Siedepunkt erreichen, bevor sich das Sicherungsmaterial verflüssigt. Das Schmelzmittel geht dann zumindest teilweise in den gasförmigen Zustand über. Der Druck, den das Schmelzmittel aufbaut, kann das Sicherungsmaterial und die Oxidschicht folglich zerreißen bzw. sprengen.

Bei den Sicherungselementen aus Weichlotmaterial muss sichergestellt werden, dass der Körper, also insbesondere der frei schwebende Sicherungsabschnitt, beim Verarbeiten des Sicherungselements nicht beschädigt wird. Das Sicherungselement muss also prozesssicher verbaut werden können. In einer Ausführungsform wird das Sicherungselement aus Lötzinn von einer Seite in den Sicherungsträger gesteckt und auf der gegenüberliegenden Seite des Sicherungsträgers verlötet. Der Körper des Sicherungselements ist so beim Lötvorgang durch den Sicherungsträger von der Hitzequelle getrennt. Folglich wird das Risiko, dass der Körper eines Sicherungselements beim Verlöten beschädigt wird, minimiert.

Ist im Rahmen dieser Offenbarung von einer Verbindung mittels Löten die Rede, kann diese selbstverständlich durch jede andere Art der elektrischen Verbindung, z.B. Kleben, Verpressen, Durchsetzfügen oder dergleichen ersetzt werden.

Für die Nutzung der Sicherungseinrichtung in Kraftfahrzeugen wird die Sicherungseinrichtung in einem Gehäuse, dessen geometrische Abmessungen genormt sind, untergebracht. Die diesbezüglich international gültige Norm ist die ISO 8820-3, insbesondere ISO 8820-3:2010(E) (Road vehicles - Fuse-links - Part 3: Fuse-links with tabs (blade type) Type C (medium), Type E (high current) and Type F (miniature)). Der streng begrenzte Gehäusebauraum kann jedoch dazu führen, dass der als Schmelzleiter dienende gebogene Draht mit einer Gehäuseinnenwand kollidiert.

Die elektrische Sicherungseinrichtung ist bevorzugt in einem Gehäuse angeordnet, aus dem zwei Kontakte oder besser Kontaktbleche herausstehen. In diesem Fall sind zwei Kontaktbleche, die vorzugsweise entsprechend der ISO 8820-3:2010 ausgeformt sind, auf der ersten Seite des Trägers aufgebracht und mit jeweils einer der beiden Leiterbahnen elektrisch leitend verbunden, wobei der Träger derart in dem Gehäuse platziert ist, dass die Kontaktbleche teilweise aus dem Gehäuse herausragen und bezüglich der Dicke des Gehäuses zentriert angeordnet sind. Ein Vorteil hiervon besteht darin, dass der Träger asymmetrisch in dem z.B. nach ISO 8820-3:2010(E) genormten Gehäuse angeordnet ist, wodurch mehr Platz zwischen Träger und Gehäuseinnenwand geschaffen wird. Der bügelförmige Draht kann somit kollisionsfrei im Gehäuse untergebracht werden und die Auslösecharakteristik der Sicherungseinrichtung wird nicht mehr durch das Gehäuse beeinflusst. Desweiteren bietet die beschriebene Anordnung den Vorteil, dass die Kontaktbereiche zur Kontaktierung mit einem Gegenkontakt nicht mehr aus auf den Träger aufgebrachten Leiterbahnen bestehen, sondern durch die mechanisch robusteren Kontaktbleche gebildet werden, sodass die Leiterbahnen beim Einstecken der Sicherungseinrichtung in einen Gegenkontakt nicht vom Träger abgeschält oder beschädigt werden können. Die Kontaktbleche können exakt mit den durch die Norm ISO 8820-3:2010(E) vorgeschriebenen Maßen gefertigt werden und sind zu denen herkömmlicher Sicherungen identisch. Wie von der Norm gefordert, sind die Kontaktbleche trotz asymmetrisch angeordnetem Träger zentriert bezüglich der Dicke des Gehäuses angeordnet. Besonders einfach können die Kontaktbleche durch Ausstanzen aus einem Blech, beispielsweise einem Kupfer- oder Messingblech, hergestellt werden. Weiterhin weisen die Kontaktbleche einen höheren Schmelzpunkt als der bügelförmige Draht auf, dadurch wird verhindert, dass sich die Kontaktbereiche bei Erwärmung verformen. Durch die Kontaktbleche kann somit jederzeit eine zuverlässige Kontaktierung mit den Gegenkontakten gewährleistet werden.

In einer bevorzugten Ausführungsform besteht das Gehäuse aus zwei Gehäusehälften, wobei eine erste Gehäusehälfte einen Hohlraum zur Aufnahme des Drahtbügels und eine zweite Gehäusehälfte eine Aufnahme und ggf. Befestigung für den Träger ausbildet. Dadurch lässt sich die Sicherungseinrichtung sehr einfach in das Gehäuse integrieren. Zuerst werden die Kontaktbleche auf den Träger aufgebracht und der Draht in die Durchkontaktierungen eingelötet. Anschließend wird der Träger in die zweite Gehäusehälfte eingelegt, wobei die zweite Seite des Trägers der Gehäuseinnenwand der zweiten Gehäusehälfte zugewandt ist, und das Gehäuse mittels der ersten Gehäusehälfte verschlossen wird. Der Hohlraum in der ersten Gehäusehälfte garantiert, dass der Drahtbügel die Gehäuseinnenwand der ersten Gehäusehälfte nicht berührt. Die beiden Gehäusehälften können durch Verrasten, Verkleben, Verschweißen oder ähnlichen Verfahren miteinander verbunden werden.

Vorteilhafterweise sind die beiden Gehäusehälften identisch. In dieser Ausgestaltung sind beide Gehäusehälften gleichzeitig die Aufnahme für den Träger als auch den Hohlraum für den Draht aus.

Dadurch können zum einen die Produktionskosten gesenkt werden, da nur eine Werkzeugform für die Herstellung des Gehäuses notwendig ist. Zum anderen können auch Beschädigungen bei der Montage ausgeschlossen werden, da die erste und zweite Gehäusehälfte bei der Montage nicht vertauscht werden können.

Bevorzugt ist ein Scheitelpunkt des Drahtbügels von einer diesem zugewandten Innenwand des Gehäuses beabstandet. Insbesondere beträgt der Abstand zwischen Scheitelpunkt des Drahtbügels und der diesem zugewandten Innenwand zwischen 0,8 mm und 2 mm, insbesondere mindestens 1 mm. Durch den Abstand ist garantiert, dass der Drahtbügel die Innenwand des Gehäuses nicht berührt und der Drahtbügel kollisisionfrei im Gehäuse untergebracht ist. Beschädigungen am Drahtbügel durch das Gehäuse können auf diese Weise ebenso ausgeschlossen werden, wie thermische Beeinflussungen der Sicherung durch Abführen der Wärme ins Gehäuse. Somit kann ein zuverlässiges Auslösen der Sicherungseinrichtung garantiert werden.

Für die Integration der Sicherungseinrichtung in das Gehäuse, insbesondere wenn das Gehäuse aus zwei identischen Gehäusehälften besteht, ist es weiterhin vorteilhaft, wenn der Abstand zwischen Träger und Scheitelpunkt des Drahtbügels kleiner oder gleich dem Abstand des Trägers zum Gehäusezentrum, also dem Mittelpunkt zwischen den beiden Gehäusehälften, und der Dicke des Trägers entspricht. Der Abstand des Trägers zum Gehäusezentrum ist durch die aufgebrachten Kontaktbleche festgelegt, da diese, um die Norm zu erfüllen, bezüglich der Dicke des Gehäuses zentriert angeordnet sein müssen. Bei identisch ausgebildeten Gehäusehälften entspricht der Abstand zwischen Gehäuseinnenwand der ersten Gehäusehälfte und der ersten Seite des Trägers somit mindestens der Summe aus der Dicke des Trägers und der Dicke der Kontaktbleche. Bei der Verwendung eines Drahtbügels, dessen Abstand zwischen Träger und Scheitelpunkt kleiner ist als der Abstand des Trägers zum Gehäusezentrum und der Dicke des Trägers kann daher sichergestellt werden, dass der Draht nicht mit der Gehäuseinnenwand kollidiert.

Weiterhin ist es vorteilhaft, wenn die Kontaktbleche gekröpft sind. Durch die Kröpfung kann der Abstand des Trägers zum Gehäusezentrum vergrößert werden, während die Kontaktbleche bezüglich der Dicke des Gehäuses immer noch zentriert angeordnet sind. Dadurch steht für die Unterbringung des gebogenen Drahts mehr Platz zwischen erster Seite des Trägers und der der ersten Seite zugewandten Gehäuseinnenwand zur Verfügung.

Für eine optimale Kontaktierung der Leiterbahnen mit den Kontaktblechen ist weiterhin vorgesehen, dass die beiden Leiterbahnen jeweils eine Kontaktzone ausbilden, die in ihrer geometrischen Form und Größe an die der Kontaktbleche angepasst ist. Dadurch ergibt sich eine großflächige Auflagefläche der Kontaktbleche auf den Leiterbahnen, die zum Verlöten der Kontaktbleche mit den Leiterbahnen genutzt wird, sodass eine zuverlässige Kontaktierung zwischen Kontaktblech und Leiterbahn erreicht wird.

In einer weiteren vorteilhaften Ausgestaltung ist vorgesehen, dass im Bereich der Kontaktzone eine oder mehrere weitere Durchkontaktierungen in den Träger eingebracht sind. Dies ermöglicht einen elektrischen Kontakt von der zweiten Seite des Trägers mit einer auf der ersten Seite des Trägers aufgebrachten Leiterbahn herzustellen. Die Kontaktbleche können dadurch beispielsweise zusätzlich von der Rückseite aus mit den Leiterbahnen verlötet werden.

Um eine zuverlässige Kontaktierung der Kontaktbleche mit den Leiterbahnen weiter zu unterstützen, können das erste und zweite Kontaktblech Kontaktelemente aufweisen, die sich in die Durchkontaktierung der Kontaktzone erstrecken und mit den Durchkontaktierungen verlötet sind. Die Kontaktbleche können dadurch direkt über die Rückseite mit den Durchkontaktierungen kontaktiert oder verlötet werden. Als Kontaktelemente eignen sich insbesondere ausgestanzte und gebogene Kontaktlaschen. Das Ausstanzen der Kontaktlaschen kann im selben Schritt erfolgen wie das Ausstanzen der Kontaktbleche.

Die Lötstelle, mittels der die Kontaktbleche mit den Leiterbahnen verbunden sind, darf nicht mechanisch beansprucht werden, da sich die Lötverbindung sonst lösen könnte. Zumindest eines der beiden Kontaktbleche oder beide Kontaktbleche weisen daher vorteilhafterweise jeweils ein Durchgangsloch auf. Das Durchgangsloch kann bereits im selben Stanzvorgang, in welchem auch die Kontaktbleche und/oder die Kontaktlaschen hergestellt werden, eingebracht werden. Ein am Gehäuse angeformter Vorsprung, z.B. ein Zapfen, greift formschlüssig in das Durchgangsloch ein, hält die Kontaktbleche an dem Gehäuse und bildet somit eine Zugentlastung für die Lötstelle.

In einer bevorzugten Ausgestaltung sind die Kontaktbleche an einem Seitenrand des Trägers auf diesen aufgebracht und der Draht in der Nähe eines den Kontaktblechen gegenüberliegenden Seitenrands angeordnet. Insbesondere verläuft der Draht parallel zu diesem Seitenrand. Durch diese Anordnung kann eine kompakte Ausgestaltung des Trägers erzielt und gleichzeitig ausreichend Fläche zum Aufbringen der Kontaktbleche bereitgestellt werden. Außerdem wird der Drahtbügel dadurch in einen Bereich des Gehäuses verlagert, indem die Innengeometrie des Gehäuses nicht durch die Kontaktbleche bzw. die mit den Kontaktblechen zusammenwirkende Zugentlastung vorgegeben wird. Die Innengeometrie des Gehäuses kann somit im Bereich des Drahtbügels optimal auf diesen abgestimmt und ein entsprechender Hohlraum bereitgestellt werden.

Zusätzlich wird auf diese Weise möglichst viel Fläche zwischen den Kontaktblechen und dem Drahtbügel geschaffen, die genutzt wird, um die Länge der aufgebrachten Leiterbahnen an die Auslösecharakteristik der Sicherungseinrichtung anzupassen. Insbesondere können die Leiterbahnen mäanderförmig aufgebracht sein. Besonders vorteilhaft ist es dabei, wenn der Drahtbügel auch noch zentriert zu den beiden anderen Seitenrändern durch den Träger gesteckt ist. Somit können die beiden Leiterbahnen symmetrisch zueinander ausgestaltet werden. Dies wirkt sich weiter positiv auf die Auslösecharakteristik der Sicherungseinrichtung aus.

Weiterhin ist es vorteilhaft, wenn der Träger auf der ersten Seite und auf der zweiten Seite im Wesentlichen deckungsgleich aufgebrachte Leiterbahnen aufweist, die über Durchkontaktierungen miteinander verbunden sind. Die Durchkontaktierungen sind dabei zum einen für das Durchstecken des bügelförmigen Drahts gedacht. Eine oder mehrere weitere Durchkontaktierungen sind in den Bereichen, die für das Aufbringen und Verbinden der Kontaktbleche mit den Leiterbahnen ausgebildet sind, vorgesehen. Auf diese Weise wird erreicht, dass auf beiden Seiten des Trägers ein elektrischer Strom gleicher Stärke bzw. gleichen Betrags fließt. Der Träger erwärmt sich somit von beiden Seiten gleichmäßig und verbiegt sich nicht auf Grund einer ungleichmäßigen Erwärmung.

Bei dieser Ausgestaltung des Trägers ist es weiterhin vorteilhaft, wenn der Träger derart in dem Gehäuse platziert wird, dass die auf der zweiten Seite des Trägers aufgebrachten Leiterbahnen die Gehäuseinnenwand nicht berühren. Dadurch wird ein zuverlässiges Auslösen der Sicherung im Gehäuse zusätzlich unterstützt, da die im Draht und den Leiterbahnen erzeugte Wärme nicht in das Gehäuse abfließen kann. Weiterhin wird dadurch verhindert, dass sich die Gehäusewände zu stark erwärmen, wodurch sie beschädigt werden könnten.

Einander zugewandte Leiterbahnendabschnitte der Leiterbahnen sowie das darunter angeordnete Trägerelement können Aussparungen aufweisen, welche jeweilige Längsenden des Schmelzleiters umschließen. Die Längsenden des Schmelzleiters sind im Bereich der Aussparungen stoffschlüssig mit den Leiterbahnendabschnitten verbunden. Vorteilhafte Ausgestaltungen des erfindungsgemäßen Verfahrens sind dabei als vorteilhafte Ausgestaltung der erfindungsgemäßen Sicherungseinrichtung anzusehen. Vorzugsweise ist der Schmelzleiter linear ausgeformt und zumindest im Wesentlichen plan zu den Leiterbahnen ausgerichtet oder in einer Richtung quer zur Haupterstreckungsebene der Leiterbahnen nach innen versetzt angeordnet, sodass die Sicherungseinrichtung in dieser Querrichtung, also quer zur Haupterstreckungsebene der Leiterbahnen, besonders schmal ausgebildet sein kann. Vorzugsweise ist der Schmelzleiter in Form einer Art geraden Verbindungslinie ausgebildet, welche die Leiterbahnendabschnitte miteinander verbindet. Die Abmaße der Sicherungseinrichtung in Querrichtung werden somit nicht oder kaum durch den Schmelzleiter bestimmt.

Eine vorteilhafte Ausführungsform der Sicherungseinrichtung sieht vor, dass zwischen den Leiterbahnendabschnitten eine als Freiraum für den Schmelzleiter dienende Durchgangsöffnung im Trägerelement ausgebildet ist, an welche die Aussparungen angrenzen. Sollte während des Betriebs der Schmelzleiter auslösen, also durchschmelzen, so kann dieser aufgrund des Freiraums im Trägerelement in jeder Raumlage frei durchhängen und dann durch den Einfluss der Schwerkraft abreißen, ohne das als Platine dienende Trägerelement zu berühren.

Schließlich ist es gemäß einer weiteren vorteilhaften Ausführungsform vorgesehen, dass die am Trägerelement angeordneten Aussparungen mit einer metallischen Beschichtung versehen sind, mit welcher die Längsenden des Schmelzleiters stoffschlüssig verbunden sind. Vorzugsweise handelt es sich bei der metallischen Beschichtung um Kupfer, wobei der Schmelzleiter aus Zinn hergestellt wird. Durch eine entsprechende Wärmeeinbringung kann also der Schmelzleiter an seinen Enden aufgeschmolzen werden, ohne dass die metallische Beschichtung an den Aussparungen des Trägerelements aufschmilzt. Mit anderen Worten ist es dadurch also auf einfache und kontrollierte Weise möglich, den Schmelzleiter mit der metallischen Beschichtung an den Aussparungen zu verlöten.

Wie dargestellt bezieht sich die vorgestellte Idee auch auf ein Verfahren zum Herstellen einer elektrischen Sicherungsvorrichtung. Das Verfahren umfasst den Schritt des Bereitstellens eines elektrisch isolierenden Trägers mit einer ersten und einer zweiten Leiterbahn, die auf dem Träger aufgebracht und um einen Spalt voneinander beabstandet sind, und mit einer ersten und einer zweiten Durchgangsöffnung durch den Träger und die erste bzw. zweite Leiterbahn. Weiterhin umfasst das erfindungsgemäße Verfahren den Schritt des Durchsteckens eines gebogenen Drahtes aus niedrigschmelzendem Metall von einer Seite des Trägers durch die Durchgangsöffnungen. Nachdem der Draht in die beiden Durchgangsöffnungen gesteckt wurde, schließt sich der Schritt des Aufschmelzens des gebogenen Drahtes auf der anderen Seite des Trägers an. Mit diesem Verfahren lässt sich auf einfache und zuverlässige Weise eine Sicherungsvorrichtung mit definierter Auslösecharakteristik herstellen.

Bevorzugt erfolgt das Aufschmelzen des Drahtes in einem Selektiv-Lötprozess. Dadurch kann die auf den Draht einwirkende Wärme örtlich und zeitlich begrenzt werden, sodass verhindert wird, dass der Draht durch die Erwärmung abschnittsweise geschwächt wird bzw. sich abschnittsweise Materialansammlungen bilden.

Alternativ könnte der Draht auch in einem Reflow-Lötprozess mit dem Träger verlötet werden. Hierzu ist es nötig, den Draht auf der Oberseite abzukapseln, um ihn vor Wärmeeinwirkung zu schützen. Der Reflow-Lötprozess bietet sich insbesondere bei der Herstellung einer Sicherung auf einer Leiterplatte an, da sowohl der Draht als auch weitere elektronische Bauelemente im selben Schritt mit der Leiterplatte verlötet werden können.

In einer vorteilhaften Weiterbildung wird vor dem Schritt des Durchsteckens des gebogenen Drahtes durch die Durchgangsöffnungen Lötstopplack derart auf den Träger aufgebracht, dass eine Freibleibung auf der ersten und/oder zweiten Leiterbahn erzeugt und niedrigschmelzendes Metall in die mindestens eine Freibleibung eingebracht wird, um einen Metallkörper zu bilden.

Durch das Aufbringen des Lötstopplacks können Form und Position des Metallkörpers genau definiert werden, da sich der Metallkörper beim Aufbringen nur bis zum Lötstopplack ausbreiten kann. Das niedrigschmelzende Metall wird bevorzugt in Form eines vorgeformten Lotdepots in die Freibleibung eingebracht und dort aufgeschmolzen. Das Aufschmelzen kann z.B. in einem Ofen, insbesondere in einem Reflow-Ofen, durchgeführt werden.

Bei dem Verfahren zum Herstellen einer Sicherungseinrichtung werden in einer Ausführungsform jeweilige Leiterbahnen mittels eines Schmelzleiters elektrisch leitend miteinander verbunden. Das Verfahren zeichnet sich dadurch aus, dass an einander zugewandten Leiterbahnendabschnitten der Leiterbahnen jeweilige Aussparungen hergestellt werden. Jeweilige Längsenden des Schmelzleiters werden dabei derart an den Aussparungen angeordnet, dass diese die Längsenden des Schmelzleiters umschließen. Die von den Aussparungen umschlossenen Längsenden des Schmelzleiters werden anschließend aufgeschmolzen und dadurch stoffschlüssig mit den Leiterbahnendabschnitten verbunden.

Der Schmelzleiter weist dabei eine wesentlich niedrigere Schmelztemperatur auf als die Leiterbahnen. Dabei ist der Schmelzleiter als Draht, insbesondere Rund- oder Flachdraht, ausgebildet sein. Zudem ist der Schmelzleiter vorzugsweise linear und ggf. flach, etwa durch (Walz-)Plattieren, ausgeformt. Die Leiterbahnen sind vorzugsweise aus Kupfer und der Schmelzleiter besteht aus einem elektrisch leitenden Material, welches eine wesentlich niedrigere Schmelztemperatur als Kupfer aufweist. Die Aussparungen an den einander zugewandten Leiterbahnendabschnitten werden vorzugsweise als Durchgangsöffnungen hergestellt. Die Aussparungen werden hinsichtlich ihrer Formgebung derart in den Leiterbahnendabschnitten hergestellt, dass diese im Wesentlichen der Form der Endabschnitte des Schmelzleiters entsprechen. Dadurch kann sichergestellt werden, dass der Schmelzleiter besonders passgenau in die zuvor hergestellten Aussparungen der Leiterbahnendabschnitte eingebracht werden kann. Durch anschließendes Aufschmelzen des entsprechend angeordneten Schmelzleiters wird dieser stoffschlüssig und somit zuverlässig mit den Leiterbahnendabschnitten verbunden.

Mittels des Verfahrens wird also die Herstellung einer Sicherungseinrichtung ermöglicht, welche zwischen ihren Leiterbahnendabschnitten einen Schmelzleiter aufweist, der die beiden Leiterbahnendabschnitte elektrisch leitend miteinander verbindet. Dadurch, dass der Schmelzleiter in die Aussparungen in den Leiterbahnendabschnitten eingebracht und anschließend stoffschlüssig mit den Leiterbahnendabschnitten verbunden wird, kann eine sehr kompakte Bauweise der Sicherungseinrichtung bei gleichzeitig zuverlässiger Auslösekennlinie der Sicherungseinrichtung sichergestellt werden.

Eine vorteilhafte Ausführung sieht vor, dass die Leiterbahnen auf einem Trägerelement hergestellt und die Aussparungen sowohl an den Leiterbahnendabschnitten als auch an dem darunter angeordneten Trägerelement hergestellt werden. Mit anderen Worten wird vorzugsweise also eine trägerbasierte Schmelzsicherung hergestellt. Bei dem Trägerelement kann es sich beispielsweise um herkömmliches Leiterplattenmaterial in Form von FR-4 oder dergleichen handeln. Dadurch, dass die Leiterbahnen auf dem Trägerelement hergestellt werden, können insbesondere auch komplexere Formen bei den Leiterbahnen auf einfache Weise realisiert werden. Beispielsweise kann zunächst Kupfer auf das Trägerelement aufgebracht und anschließend ein Teil des aufgebrachten Kupfers vom Trägerelement weggeätzt werden, sodass die Leiterbahnen auf dem Trägerelement verbleiben. Nachdem die Leiterbahnen auf dem Trägerelement hergestellt worden sind, werden die Aussparungen sowohl an den Leiterbahnendabschnitten als auch an dem darunter angeordneten Trägerelement hergestellt, beispielsweise indem die Aussparungen sowohl aus den Leiterbahnendabschnitten als auch aus dem darunterliegenden Bereich des Trägerelements herausgestanzt werden. Mit anderen Worten ist also auch möglich, dass die Aussparungen Durchgangsöffnungen durch die Leiterbahnendabschnitte und durch das darunterliegende Trägerelement bilden.

Eine weitere vorteilhafte Ausführungsform sieht vor, dass zumindest die am Trägerelement hergestellten Aussparungen mit einer metallischen Beschichtung versehen werden. Das Aufschmelzen und stoffschlüssige Verbinden des Schmelzleiters mit den Leiterbahnendabschnitten und dem Trägerelement wird dadurch erheblich begünstigt. Zudem ist es durch diese Maßnahme auch möglich, auf beiden Seiten des Trägerelements Leiterbahnen vorzusehen und diese auf besonders einfache Weise elektrisch leitend mit dem Schmelzleiter zu verbinden. Darüber hinaus wird die Wärmeleitung von den Leiterbahnen über die metallische Beschichtung bis hin zum Schmelzleiter durch die Beschichtung der Aussparungen begünstigt.

Gemäß einer weiteren vorteilhaften Ausführungsform ist es vorgesehen, dass als die metallische Beschichtung Kupfer verwendet wird. An sich ist es vorteilhaft, wenn als die metallische Beschichtung dasselbe Material verwendet wird wie bei den Leiterbahnen. Das thermische Verhalten und die Stromleitfähigkeit der metallischen Beschichtung an den Aussparungen und der Leiterbahnen sind dadurch im Wesentlichen identisch, was sich unter anderem positiv auf die Auslöseeigenschaften der als Schmelzsicherung ausgebildeten Sicherungseinrichtung und somit auf ihre Schmelzkennlinie auswirkt.

In weiterer vorteilhafter Ausgestaltung ist es vorgesehen, dass der Schmelzleiter flach in den Aussparungen angeordnet und mit dem Trägerelement verlötet wird. Mit anderen Worten wird der Schmelzleiter also plan in den hergestellten Aussparungen angeordnet. Vorzugsweise bildet der Schmelzleiter eine gerade Verbindungslinie zwischen den beiden Leiterbahnendabschnitten, wobei die Längsenden des Schmelzleiters innerhalb der Aussparungen der Leiterbahnendabschnitte aufgenommen und stoffschlüssig mit diesen verbunden werden. Dadurch, dass der Schmelzleiter flach, also plan in den Aussparungen angeordnet und mit dem Trägerelement, vorzugsweise mit der metallischen Beschichtung an den Aussparungen des Trägerelements, verlötet wird, wird der Schmelzleiter besonders platzsparend innerhalb der Sicherungseinrichtung untergebracht. Der Schmelzleiter hat genügend Platz, um entsprechend notwendige Mindestabstände zu dem restlichen Trägerelement und zu einem Gehäuse der Sicherungseinrichtung einzuhalten. Außerdem kann der Schmelzleiter vorzuweisen in jeder Raumlage frei durchhängen und dann durch den Einfluss der Schwerkraft abreißen, ohne das als Platine dienende Trägerelement zu berühren.

In weiterer vorteilhafter Ausgestaltung ist es vorgesehen, dass die Längsenden des Schmelzleiters so tief in den Aussparungen versenkt angeordnet werden, dass der Schmelzleiter die aus den Leiterbahnen und Trägerelement ausgebildete Leiterplatte in Querrichtung der Leiterplatte nicht überragt. Beispielsweise können die Längsenden des Schmelzleiters so tief in den Aussparungen versenkt angeordnet bzw. in diese hineingedrückt werden, dass der Schmelzleiter zumindest bündig mit den Leiterbahnen abschließt, diese also in Querrichtung der Leiterplatte nicht überragt. Alternativ ist es aber auch möglich, dass die Längsenden des Schmelzleiters so tief in den Aussparungen versenkt werden, dass die Leiterbahnen in Querrichtung der Leiterplatte den Schmelzleiter etwas überragen. So oder so wird dadurch eine besonders kompakte Bauweise der Sicherungseinrichtung möglich, da die maximalen Querabmessungen der Sicherungseinrichtung nicht durch den eingebrachten Schmelzleiter beeinflusst werden.

Eine weitere vorteilhafte Ausführungsform sieht vor, dass die Aussparungen als Presspassungen dimensioniert und die Längsenden des Schmelzleiters vor dem Aufschmelzen in die Aussparungen hineingepresst werden. Mit anderen Worten werden die Aussparungen also derart hergestellt, dass diese etwas enger sind als die Außenabmaße der Längsenden des Schmelzleiters, d.h., dass die Längsenden breiter sind als die Aussparungen. Durch das Hineinpressen der Längsenden des Schmelzleiters in die als Presspassungen dimensionierten Aussparungen erfolgt also eine Kaltverformung der Längsenden des Schmelzleiters, wodurch eine besonders zuverlässige Verbindung zwischen den Längsenden des Schmelzleiters und den Aussparungen hergestellt werden kann. Durch das Hineinpressen der Längsenden des Schmelzleiters wird also dessen Form an die Formgebung der Aussparungen angepasst, sodass die Längsenden des Schmelzleiters vollständig oder zumindest schon größtenteils flächig innerhalb der Aussparungen an entsprechenden Seiten bzw. Wandungen der Aussparungen anliegen. Beim anschließenden Aufschmelzen der Längsenden des Schmelzleiters können diese besonders zuverlässig stoffschlüssig mit den Leiterbahnendabschnitten und gegebenenfalls zusätzlich noch mit den beschichteten Aussparungen im Trägerelement verbunden werden. Alternativ ist es auch möglich, die Aussparungen geringfügig größer als die Längsenden des Schmelzleiters zu dimensionieren, also als Spielpassung, indem die Aussparungen etwas breiter als die Längsenden des Schmelzleiters dimensioniert werden. Dies hätte den Vorteil, dass sich das Einlegen des Schmelzleiters in die Aussparungen einfacher gestaltet, da nur wenig oder gar kein Kraftaufwand dafür notwendig ist. Zudem fallen in diesem Fall die Anforderungen an die Positionierungsgenauigkeit beim Anordnen der Schmelzleiterenden in den Aussparungen relativ gering aus. Vorzugsweise wird ein Gegenhalter unterhalb von den Aussparungen positioniert, wobei die in den Aussparungen angeordneten Längsenden des Schmelzleiters dann beispielsweise mittels eines Stempels auf den Gegenhalter gedrückt und dadurch kaltverformt werden. Infolgedessen breiten sich die Längsenden des Schmelzleiters aus und werden an die Wandungen der Aussparungen angelegt bzw. an diese angepresst. Vorzugweise wird unabhängig von der Art der Passung der Aussparungen immer ein Gegenhalter unterhalb von den Aussparungen angeordnet, bevor die Längsenden des Schmelzleiters in die Aussparungen gepresst bzw. gedrückt werden.

Vorzugsweise werden die Längsenden des Schmelzleiters mittels eines Stempels in die Aussparungen hineingepresst. Dadurch können die Längsenden des Schmelzleiters auf besonders einfache Weise in die Aussparungen eingebracht und an entsprechende Wandungen der Aussparungen angelegt werden.

Gemäß einer weiteren vorteilhaften Ausführungsform ist es vorgesehen, dass die Aussparungen derart hergestellt werden, dass die Leiterbahnendabschnitte und/oder das Trägerelement die Aussparungen jeweils von drei Seiten umgeben. Beispielsweise können die Aussparungen derart hergestellt werden, dass diese in einer Draufsicht auf die Leiterplatte eine Art U-förmige Aussparung bilden, sodass die Leiterbahnendabschnitte von jeweils drei Seiten der Aussparungen umschlossenen werden. Andere Formgebungen der Aussparungen sind aber ebenfalls möglich, wobei wie bereits erwähnt die Aussparungen hinsichtlich ihrer Formgebung vorzugsweise an die Formgebung der Längsenden des Schmelzleiters angepasst sind, also quasi eine Negativform der Längsenden des Schmelzleiters bilden. Dadurch können die Längsenden des Schmelzleiters auf besonders zuverlässige Weise in die zuvor hergestellten Aussparungen eingepasst bzw. eingepresst werden, um die Längsenden des Schmelzleiters mit den Aussparungen schon einmal mechanisch zu kontaktieren, bevor die Längsenden des Schmelzleiters aufgeschmolzen werden.

In weiterer vorteilhafter Ausgestaltung ist es vorgesehen, dass der Schmelzleiter aus einem Zinndraht, zum Beispiel einem Rund- oder Flachdraht, abgelängt wird. Der Zinndraht kann beispielsweise in Form eines Endlosmaterials bereitgestellt werden, wobei der gerade jeweils erforderliche Schmelzleiter aus diesem Zinndraht abgelängt also von diesem abgetrennt wird. Dadurch kann der Schmelzleiter auf besonders einfache und kostengünstige Weise bereitgestellt werden.

Gemäß einer weiteren vorteilhaften Ausführungsform ist es vorgesehen, dass der Schmelzleiter derart hergestellt wird, dass dieser einen aus einem Flussmittel hergestellten Kern einschließt, vorzugsweise vollständig umschließt. Mit anderen Worten wird also ein Zinndraht mit innenliegendem Flussmittel verwendet. Durch das im Schmelzleiter vorhandene Flussmittel kann verhindert werden, dass das eigentliche Schmelzleitermaterial während des Aufschmelzens der Längsenden des Schmelzleiters durch den in der Umgebungsluft enthaltenen Sauerstoff oxidiert wird. Ferner kann durch das Flussmittel auch verhindert werden, dass der Schmelzleiter während des Betriebs, insbesondere wenn der Schmelzleiter durch einen entsprechenden Stromfluss erwärmt wird, oxidiert wird. Statt eines massiven Zinndrahts mit oberflächlich aufgebrachtem Flussmittel wird also vorzugsweise ein Zinndraht mit einer innenliegenden Seele aus Flussmittel verwendet, wobei es sich bei dem Flussmittel beispielsweise um handelsübliches Lötzinn handeln kann. Das innenliegende Flussmittel ist vor Umgebungseinflüssen geschützt und kann auch nicht abbröckeln oder anderweitig verloren gehen. Wenn der Schmelzleiter beginnt, sich zu verflüssigen, also aufzuschmelzen, dann hat sich bereits zuvor das innenliegende Flussmittel verflüssigt und brodelt somit im Inneren des Schmelzleiters, baut einen entsprechenden Innendruck auf und reißt mechanisch das durch An- oder Aufschmelzen teigige oder bereits flüssige Material des Schmelzleiters samt Oxidschicht auf, wodurch der Schmelzleiter bestimmungsgemäß unterbrochen wird. Ferner kann es auch noch vorgesehen sein, dass neben dem Flussmittel auch andere Füllmaterialien im Inneren des Schmelzleiters vorgesehen werden, die einen niedrigeren Schmelzpunkt als der Schmelzleiter aufweisen. Die Funktion des Schmelzleiters kann auch bei größeren Leitungs- und somit Zinndrahtquerschnitten sichergestellt werden. Insbesondere kann ein besonders zuverlässiger und sicherer Betrieb des Schmelzleiters auch über längere Produktlebensdauern sichergestellt werden, da das Flussmittel vor Umwelteinflüssen abgeschirmt ist und zudem nicht vom Schmelzleiter abgetrennt werden kann. Darüber hinaus ergibt sich eine besonders einfache und somit günstige Fertigung des Schmelzleiters selbst, da nicht nachträglich erst der Schmelzleiter mit einem Flussmittel benetzt werden muss.

In weiterer vorteilhafter Ausgestaltung der Erfindung ist es vorgesehen, dass zum Aufschmelzen der Längsenden des Schmelzleiters dieser indirekt erwärmt wird, indem Wärme in die Leiterbahnen eingebracht wird. Vorzugsweise wird dicht neben dem Schmelzleiter an den Leiterbahnen Wärme eingebracht, und zwar so dosiert, dass der Schmelzleiter anschmilzt, aber nicht vollständig durchschmilzt. Beispielsweise kann die zum Aufschmelzen der Längsenden des Schmelzleiters erforderliche Wärmeenergie mittels eines Lötkolbens oder auch mittels eines Lasers eingebracht werden, indem der Lötkolben oder der Laser auf die Leiterbahnendabschnitte gerichtet wird, welche die Aussparungen umschließen, in welchen die Enden des Schmelzleiters aufgenommen sind. Der Vorteil dieser Vorgehensweise besteht darin, dass die Leiterbahnen einen wesentlich höheren Schmelzpunkt aufweisen als der Schmelzleiter selbst, sodass die Aufschmelzung der Längsenden des Schmelzleiters auf diese Art und Weise wesentlich besser kontrolliert werden kann. Dadurch kann verhindert werden, dass der Schmelzleiter auf unerwünschte Weise vollständig durchschmilzt, was durchaus passieren könnte, wenn die zum Aufschmelzen des Schmelzleiters notwendige Wärmeenergie direkt am Schmelzleiter eingebracht werden würde. Aufgrund des höheren Schmelzpunktes der Leiterbahnen kann also bei der Wärmeeinbringung in die Leiterbahnen eine besonders einfache Prozessführung zum Aufschmelzen der Schmelzleiterenden ermöglicht werden. Insbesondere können die Leiterbahnen dadurch auch einen Teil der in diese eingebrachten Wärme puffern, wodurch sich die Prozessführung beim Aufschmelzen der Schmelzleiterenden vereinfacht.

### Kurze Figurenbeschreibung

Nachfolgend wird ein vorteilhaftes Ausführungsbeispiel der Erfindung unter Bezugnahme auf die begleitenden Figuren erläutert. Es zeigen:
- Fig. 1: eine schematische Darstellung einer erfindungsgemäßen Sicherungsvorrichtung in einer Draufsicht;
- Fig. 2: eine Querschnittsansicht der in Fig. 1 dargestellten Sicherungsvorrichtung;
- Fig. 3: ein alternatives Ausführungsbeispiel einer erfindungsgemäßen Sicherungsvorrichtung in einer Querschnittsansicht;
- Fig. 4: weitere Ausgestaltungen einer erfindungsgemäßen Sicherungsvorrichtung in einer Querschnittsansicht;
- Fig. 5: zeigt eine erfindungsgemäße Sicherungsvorrichtung mit angelegten Wärmedepots als Draufsicht;
- Fig. 6: als Draufsicht die Verwendung einer erfindungsgemäßen Sicherungsvorrichtung in einer Multifuse;
- Fig. 7a - 7e: in Querschnittsansichten ein Verfahren zum Herstellen einer erfindungsgemäßen Sicherungsvorrichtung;
- Fig. 8: die in Fig. 7e dargestellte Sicherungsvorrichtung in einem ausgelösten Zustand;
- Fig. 9: eine schematische Darstellung eines Ausführungsbeispiels einer erfindungsgemäßen Sicherungsvorrichtung;
- Fig. 10: eine schematische Schnittansicht eines Ausführungsbeispiels einer erfindungsgemäßen Sicherungsvorrichtung;
- Fig. 11: eine schematische Schnittansicht eines weiteren Ausführungsbeispiels einer erfindungsgemäßen Sicherungsvorrichtung; und
- Fig. 12: ein Ablaufdiagramm eines Ausführungsbeispiels eines erfindungsgemäßen Verfahrens;
- Fig. 13: eine Draufsicht auf eine erfindungsgemäße Sicherungsvorrichtung ohne Gehäuse;
- Fig. 14: eine erfindungsgemäße Sicherungsvorrichtung mit einem erfindungsgemäßen Gehäuse in einer Schnittansicht;
- Fig. 15: eine Draufsicht auf den Träger einer erfindungsgemäßen Sicherungsvorrichtung ohne aufgebrachte Kontaktbleche;
- Fig. 16: eine Draufsicht auf eine Sicherungsvorrichtung, welche zwei Leiterbahnen aufweist, die auf einem Trägermaterial angeordnet sind, wobei jeweilige einander zugewandte Leiterbahnendabschnitte einander zugewandte Aussparungen aufweisen;
- Fig. 17: eine weitere Draufsicht auf die Sicherungsvorrichtung, wobei ein Schmelzleiter der Sicherungsvorrichtung an den gegenüberliegend angeordneten Aussparungen der Leiterbahnendabschnitte angeordnet worden ist; und in
- Fig. 18: eine weitere Draufsicht auf die Sicherungsvorrichtung, wobei jeweilige Längsenden des Schmelzleiters, die von den Aussparungen umschlossen sind, aufgeschmolzen worden und dadurch stoffschlüssig mit den Leiter-bahnendabschnitten verbunden worden sind.

Die Figuren sind lediglich schematische Darstellungen und dienen nur der Erläuterung der Erfindung. Gleiche oder gleichwirkende Elemente sind durchgängig mit den gleichen Bezugszeichen versehen.

### Detaillierte Beschreibung

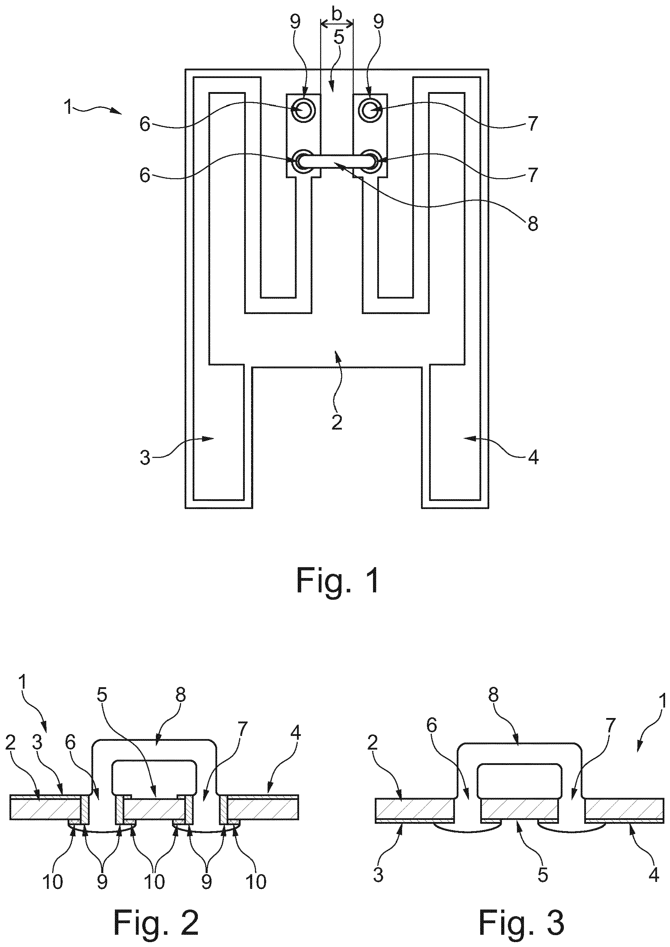

In Fig. 1 ist schematisch der Aufbau eines Ausführungsbeispiels einer erfindungsgemäßen elektrischen Sicherungsvorrichtung 1 dargestellt. Die elektrische Sicherungsvorrichtung 1 besteht aus einem plattenförmigen elektrisch isolierenden Träger 2 aus Keramik oder einem herkömmlichem Leiterplattenmaterial, wie beispielsweise FR4. Der Träger hat eine Breite von etwa 18 mm und eine Länge von etwa 26 mm. Auf der hier gezeigten Vorderseite des Trägers 2 sind eine erste Leiterbahn 3 und eine zweite Leiterbahn 4 mäanderförmig und symmetrisch zueinander aufgebracht. Die beiden Leiterbahnen 3, 4 bestehen aus Kupfer und haben jeweils eine Dicke von ca. 0,250 mm. Die beiden Leiterbahnen 3, 4 sind durch einen Spalt 5 mit einer bevorzugten Spaltbreite b von ca. 2,5 mm voneinander getrennt.

Im Bereich des Spalts 5 sind zwei erste Durchgangsöffnungen 6 durch den Träger 2 und durch die erste Leiterbahn 3 sowie zwei zweite Durchgangsöffnungen 7 durch den Träger und durch die zweite Leiterbahn 4 eingebracht. Die Anzahl der jeweiligen Durchgangsöffnungen 6, 7 kann je nach Anwendungsfall der elektrischen Sicherungsvorrichtung variieren. In den Durchgangsöffnungen 6, 7 ist eine elektrisch leitfähige Beschichtung 9 auf den Träger 2 aufgebracht.

Der Spalt 5 wird mit einem um ca. 180° gebogenen Draht 8 aus einem durchgehend niedrigschmelzenden Material, erfindungsgemäß ein Zinndraht, dessen erstes Ende in der ersten Durchgangsöffnung 6 und dessen zweites Ende in der zweiten Durchgangsöffnung 7 angeordnet ist, überbrückt. Der Draht hat eine kreisförmige Querschnittsfläche mit einem Durchmesser von 0,5 mm. Auf die gleiche Weise könnte ein weiterer gebogener Draht aus dem gleichen niedrigschmelzenden Material in dem zweiten Paar Durchgangsöffnungen 6, 7 platziert werden, sodass der Spalt 5 durch zwei parallel geschaltete Drähte 8 überbrückt wird.

In Fig. 2 ist die in Fig. 1 gezeigte erfindungsgemäße Sicherungsvorrichtung 1 in einer Querschnittsansicht dargestellt. In dieser Ansicht ist auch zu erkennen, dass in den Durchgangsöffnungen 6, 7 eine elektrische leitfähige Beschichtung 9 auf den Träger 2 aufgebracht ist, die elektrisch leitend mit der ersten 3 bzw. zweiten Leiterbahn 4 verbunden ist. Auf der den Leiterbahnen 3, 4 abgewandten Seite des Trägers 2 sind zusätzlich Lötflächen 10 aufgebracht, die über die elektrische Beschichtung 9 mit den Leiterbahnen 3, 4 auf der Vorderseite des Trägers 2 elektrisch leitend verbunden sind. Die beiden Enden des gebogenen Drahtes 8, mit denen der Draht 8 in jeweils eine der Durchgangsöffnungen 6, 7 gesteckt wurde, sind direkt mit den Lötflächen 10 verlötet. Die Lötflächen 10 umgeben die Durchgangsöffnungen 6, 7 ringförmig. Es wäre aber möglich, dass die Lötfläche eine an die Durchgangsöffnung angrenzende, die Durchgangsöffnungen 6, 7 nicht oder nur teilweise umgebende Fläche ist, die das niedrigschmelzende Metall beim Verlöten aufnimmt.

Ein weiteres Ausführungsbeispiel für eine erfindungsgemäße Sicherungsvorrichtung 1 ist in Fig. 3 ebenfalls in einer Querschnittsansicht gezeigt. Auf einen Träger 2 sind wieder eine erste 3 und eine zweite Leiterbahn 4, die durch einen Spalt 5 voneinander beabstandet sind, aufgebracht. Im Gegensatz zur in Fig. 1 und 2 gezeigten Ausführungsform sind die beiden Leiterbahnen 3, 4 nicht auf der Vorderseite des Trägers 2, sondern auf dessen Rückseite aufgebracht.

Der um ca. 180° gebogene Draht 8 aus einem durchgehend niedrigschmelzendem Material ist in den Durchgangsöffnungen 6, 7 derart angeordnet, dass ein Drahtende in der ersten Durchgangsöffnung 6 platziert, hierbei ca. 1-3 mm aus der Durchgangsöffnung 6 vor dem Verlöten heraussteht und direkt mit der ersten Leiterbahn 3 auf der Rückseite verlötet ist. Analog ist das andere Drahtende in der zweiten Durchgangsöffnung 7 angeordnet und direkt mit der zweiten Leiterbahn 4 verlötet. In dieser Ausführungsform verläuft der Drahtabschnitt zwischen den beiden Drahtenden auf der den beiden Leiterbahnen 3, 4 abgewandten Seite des Trägers 2 und überbrückt auf diese Weise den Spalt 5.

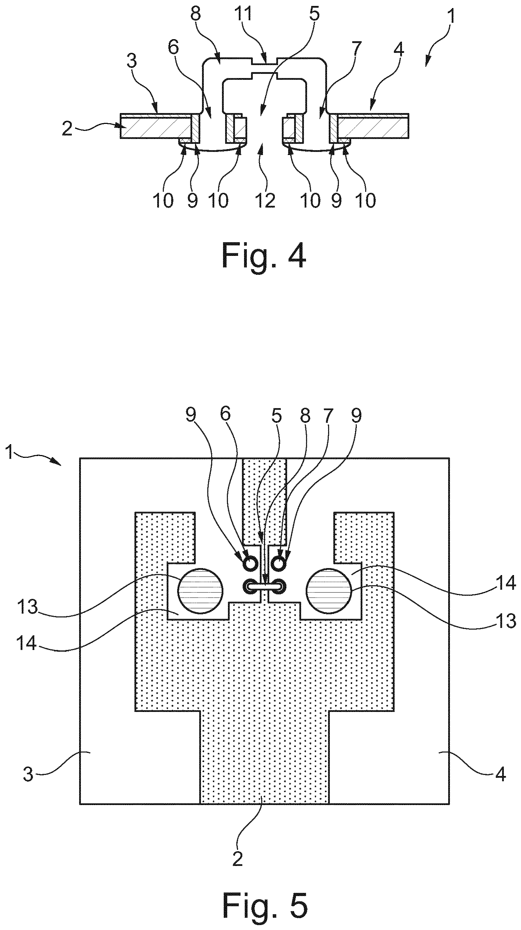

Fig. 4 zeigt weitere Ausgestaltungen einer erfindungsgemäßen elektrischen Sicherungsvorrichtung 1, bestehend aus einem Träger 2 mit einer ersten 6 und einer zweiten Durchgangsöffnung 7. Die beiden Leiterbahnen 3, 4 sind wie in Fig. 1 und 2 auf der Vorderseite des Trägers 2 aufgebracht. Der gebogene Draht 8 ist in den Durchgangsöffnungen 6, 7 angeordnet und mit Lötflächen 10 auf der den Leiterbahnen 3, 4 abgewandten Seite des Trägers 2 verlötet. Die Lötflächen 10 sind über eine elektrisch leitfähige Beschichtung 9 des Trägers 2 in den Durchgangsöffnungen 6, 7 mit den Leiterbahnen 3, 4 kontaktiert. Zwischen den beiden in den Durchgangsöffnungen 6, 7 angeordneten Drahtenden weist der gebogene Draht 8 einen Abschnitt mit teilweise vermindertem Querschnitt auf. Das Aufschmelzen des gebogenen Drahtes 8 in Folge einer Überlast wird in diesem Abschnitt begünstigt, sodass dieser Abschnitt eine Sollbruchstelle 11 darstellt. Durch Ausbilden einer solchen Sollbruchstelle 11 muss die Größe und Form der Durchgangsöffnungen 6, 7 nicht an die Auslösekriterien des Drahtes 9 angepasst werden, sondern der Draht 9 wird unter Berücksichtigung der Auslösekriterien an die Durchgangsöffnungen 6, 7 angepasst.

Im Bereich des Spalts 5 direkt unter der Sollbruchstelle 11 weist der in Fig. 4 dargestellte Träger 2 einen Durchbruch 12 auf. Im Auslösefall der Sicherung kann das geschmolzene Metall, das von der Sollbruchstelle 11 des Drahtes 9 herabtropft, durch den Durchbruch 12 abfließen, wodurch verhindert wird, dass sich das Metall auf dem Träger 2 ansammelt und einen Kurzschluss zwischen den beiden Leiterbahnen 3, 4 verursacht. Die elektrische Sicherungsvorrichtung 1 kann somit unabhängig von ihrer räumlichen Orientierung verbaut werden. Eine Alternative sieht vor, dass die Sicherungsvorrichtung 1 derart verbaut wird, dass sich der gebogene Draht 8 unterhalb der Sicherungsvorrichtung 8 befindet, sich also abtropfendes Metall von der Sicherungsvorrichtung 8 weg bewegt.

Die elektrische Sicherung 1 in Fig. 5 ist im Wesentlichen ähnlich der in Fig. 1 beschriebenen aufgebaut, umfasst jedoch auf der ersten Leiterbahn 3 und der zweiten Leiterbahn 4 in der Nähe des Spalts 5 jeweils einen aufgeschmolzenen Metallkörper 13 aus dem gleichen niedrigschmelzenden Metall wie der gebogene Draht 9. Im Bereich des Spalts 5 bilden die beiden Leiterbahnen 3, 4 verbreiterte Bereiche 14 aus, die eine Aufnahme für die aufgeschmolzenen Metallkörper 13 bilden. Die Metallkörper 13 sind so nah an dem gebogenen Draht 9 angeordnet, dass sie über die Leiterbahnen 3 bzw. 4 in thermischem Kontakt mit dem gebogenen Draht 8 stehen. Auf diese Weise dienen die Metallkörper 13 als Wärmedepot für den Draht 8, sodass dessen Aufschmelzen hinausgezögert werden kann.

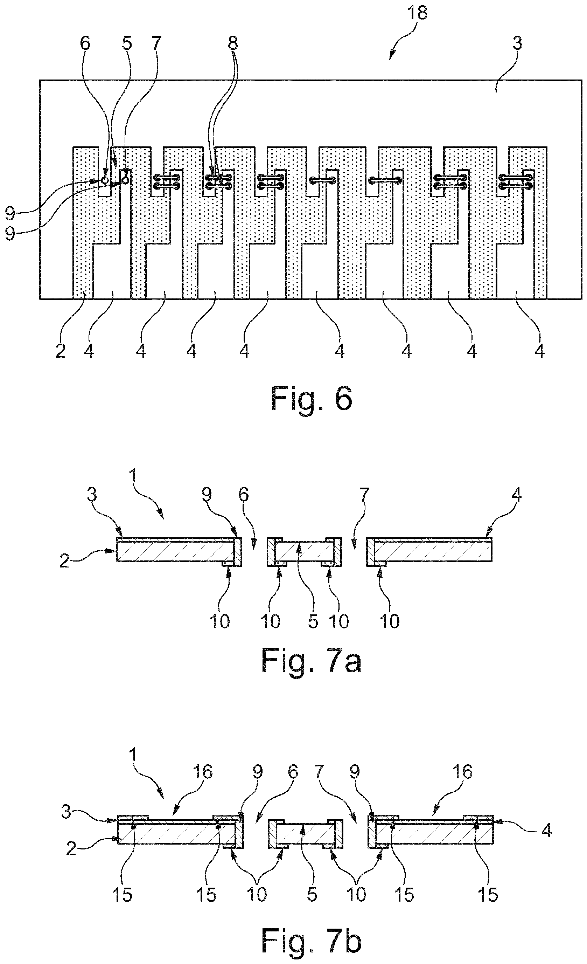

Die elektrische Sicherungsvorrichtung 18 in Fig. 6 weist mehrere auf einem gemeinsamen Träger 2 aufgebrachte Sicherungsbereiche auf. Dazu sind auf dem gemeinsamen Träger 2 eine gemeinsame erste Leiterbahn 3 und mehrere zweite Leiterbahnen 4, die folglich durch mehrere Spalte 5 voneinander beabstandet sind, aufgebracht. In der Nähe jedes Spalts 5 weist die Sicherungsvorrichtung 18 mindestens eine erste Durchgangsöffnung 6 und eine gleiche Anzahl zweiter Durchgangsöffnungen 7 durch die erste 3 bzw. zweite Leiterbahn 4 und durch den Träger 2 auf. Zur Überbrückung des Spalts 5 sind gebogene Drähte 8 in den Durchgangsöffnungen 6, 7 angeordnet und auf der den beiden Leiterbahnen 3, 4 abgewandten Seite des Trägers 2 mit Lötflächen verlötet(in Fig. 6 nicht dargestellt), die über eine elektrisch leitfähige Beschichtung des Trägers 2 in den Durchgangsöffnungen 6, 7 mit den Leiterbahnen 3, 4 elektrisch verbunden sind. Die verschiedenen Sicherungsbereiche müssen nicht gleich ausgestaltet sein. Es ist möglich, dass die verschiedenen Sicherungsbereiche eine unterschiedliche Anzahl an gebogenen Drähten 8 zur Überbrückung des Spalts 5 aufweisen. Auch können die Drähte 8 in ihrer Ausgestaltung variieren, um sie an verschiedene Auslösekriterien anzupassen. Die zweiten Leiterbahnen 4 können wie in Fig. 6 dargestellt gleich ausgebildet sein. Es ist aber auch möglich, die zweiten Leiterbahnen 4 unterschiedlich zu gestalten und insbesondere an die Charakteristiken der abzusichernden Leitungen und Schaltungen anzupassen.

Die Fig. 7a bis 7e zeigen in Schnittdarstellung ein Verfahren zum Herstellen einer elektrischen Sicherungsvorrichtung 1 bzw. 18, beispielsweise einer Sicherungsvorrichtung 1 ähnlich der in Fig. 5 gezeigten.

In Fig. 7a wird ein elektrisch isolierender Träger 2 mit einer mit einer ersten Leiterbahn 3 und einer zweiten Leiterbahn 4, die auf der Vorderseite des Trägers 2 aufgebracht und um einen Spalt 5 voneinander beabstandet sind, bereitgestellt. Der Träger weist weiterhin eine erste 6 und eine zweite Durchgangsöffnung 7 durch den Träger und die erste 3 bzw. zweite Leiterbahn 4 auf. In den Durchgangsöffnungen 6, 7 ist der Träger 2 mit einer elektrisch leitfähigen Beschichtung 9 überzogen, die eine elektrisch leitfähige Verbindung zwischen den auf der Vorderseite des Trägers 2 aufgebrachten Leiterbahnen 3, 4 und den auf der Rückseite des Trägers 2 aufgebrachten Lötflächen 10 darstellt.

Beim Aufbringen der Leiterbahnen 3, 4 auf den Träger 2 können die üblichen Verfahren zur Herstellung einer Leiterplatte Anwendung finden. Die Durchgangsöffnungen 6, 7 sind insbesondere durch Bohren hergestellte Löcher. Alternativ können sie aber auch gestanzt, gefräst, geschnitten oder mit einem ähnlichen Verfahren in den Träger 2 eingebracht werden. Die Durchgangsöffnungen 6, 7 können vor oder nach dem Aufbringen der Leiterbahnen 3, 4 in den Träger 2 eingebracht werden.

In einem in Fig. 7b gezeigten zweiten Schritt werden die beiden Leiterbahnen 3, 4, abgesehen von einer Freibleibung 16, mit Lötstopplack 15 bedeckt. Die Verwendung des Lötstopplacks 15 weist unter anderem den Vorteil auf, dass eine sehr genau geformte und positionierte Freibleibung 16 erzeugt werden kann.

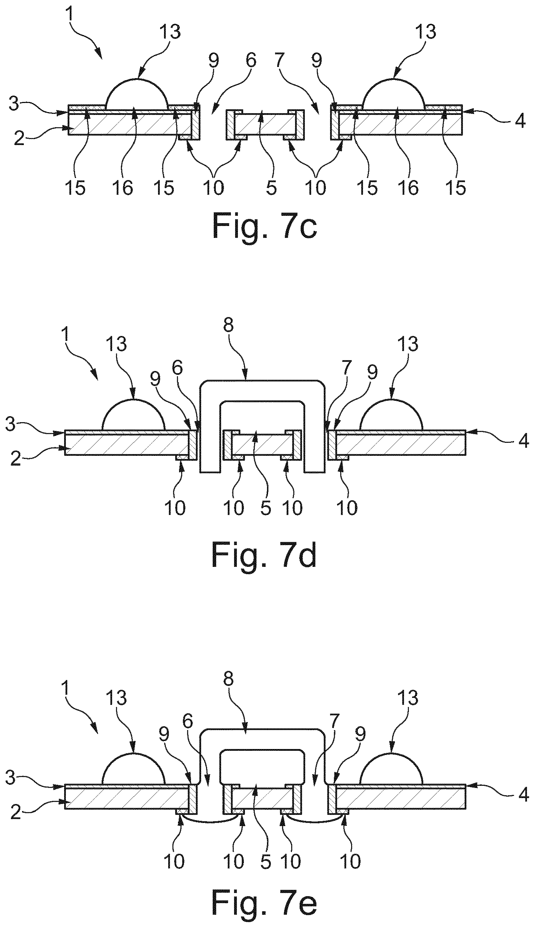

Im Folgenden, in Fig. 7c dargestellten dritten Schritt werden die Metallkörper 13 aus niedrigschmelzendem Metall in die Freibleibungen 16 eingebracht. Hierzu kann ein vorgeformtes Lotdepot in der Freibleibung 16 positioniert und mittels eines Reflow-Lötprozesses aufgeschmolzen werden. Dabei zerfließt das vorher z.B. würfelförmig bereitgestellte Lotdepot bis zu dem durch den Lötstopplack 15 erzeugten Rand der Freibleibung 16. Bei Verwendung eines abziehbaren Lötstopplacks 15 kann dieser nach Abkühlen des Metallkörpers 13 entfernt werden. Der Träger 2 kann zum Ausbilden einer Leiterplatte vor dem Aufschmelzen des Lotdepots mit weiteren elektronischen Bauteilen bestückt werden, die dann im selben Reflow-Lötprozess wie die Metallkörper 13 mit dem Träger 2 verlötet werden.

In Fig. 7d wird das Anordnen eines gebogenen Drahtes 8 aus einem durchgängig niedrigschmelzenden Metall in den Durchgangsöffnungen 6, 7 gezeigt. Dazu wurde ein gerader Draht um ca. 180° gebogen, sodass die beiden Drahtenden parallel zueinander ausgerichtet sind. Von der Vorderseite des Trägers 2 aus wird nun ein Ende des gebogenen Drahtes 8 in die erste Durchgangsöffnung 6 und das andere Ende in die dazugehörige zweite Durchgangsöffnung 7 gesteckt. Der gebogene Draht 8 wird dabei soweit in die Durchgangsöffnungen 6, 7 eingesteckt, bis auf der Rückseite des Trägers 2 die Drahtenden teilweise überstehen.

In einem abschließenden fünften Schritt, welcher in Fig. 7e dargestellt ist, wird das in der ersten Durchgangsöffnung 6 angeordnete Drahtende in einem Selektiv-Lötprozess direkt mit der Lötfläche 10, die über die elektrisch leitfähige Beschichtung 9 mit der ersten Leiterbahn 3 elektrisch leitend verbunden ist, verlötet. Analog wird das in der zweiten Durchgangsöffnung 7 angeordnete Drahtende direkt mit der Lötfläche 10 verlötet und stellt so eine elektrisch leitende Verbindung zur zweiten Leiterbahn 4 her.

Für die Herstellung einer elektrischen Sicherungsvorrichtung 1 ohne Wärmedepot, d.h. ohne Metallkörper 13, werden die in den Fig. 7b und 7c gezeigten Schritte einfach übersprungen. Alternativ wäre es auch möglich, den Reflow-Lötprozess anstatt zum Aufbringen von Metallkörpern 13 lediglich zum Bestücken des Trägers 2 mit weiteren elektronischen Bauteilen zu nutzen.

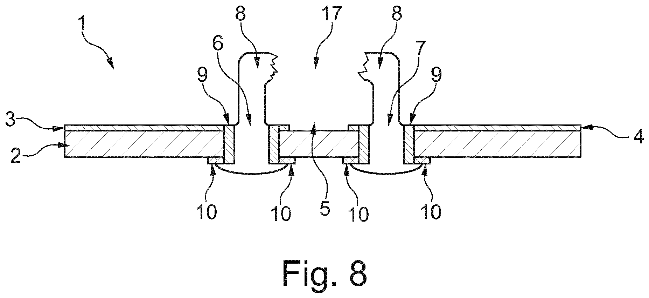

In Fig. 8 ist ein Beispiel für eine ausgelöste Sicherungsvorrichtung 1 dargestellt. Als Folge einer Überlast ist durch den gebogenen Draht 8 ein so großer elektrischer Strom geflossen, dass sich dieser über seinen Schmelzpunkt (Zinn: 231°C) hinaus erwärmt hat und geschmolzen ist. Geschmolzenes Metall des gebogenen Drahtes 8 ist solange von diesem herabgetropft, bis der Draht 8 in einem Abschnitt 17 unterbrochen ist. Die Sicherungsvorrichtung 1 wurde ausgelöst.

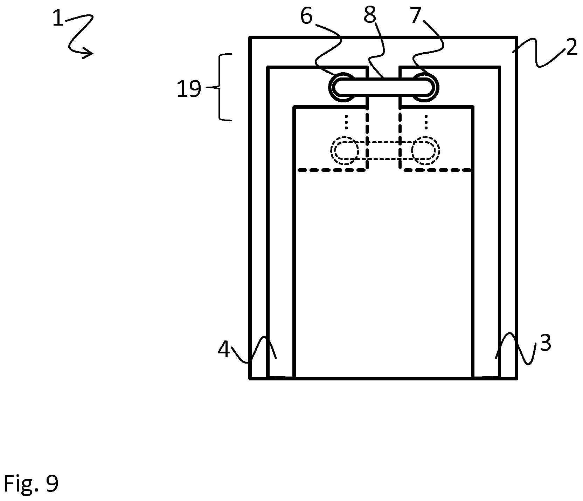

Fig. 9 zeigt einen als Leiterplatte 2 ausgebildeten Sicherungsträger. Auf der Leiterplatte 2 sind zwei elektrische Kontakte 3 und 4 dargestellt. Die Kontakte 3, 4 weisen in der bildhaften Darstellung der Fig. 9 an ihrem oberen Ende jeweils einen zu dem jeweils anderen Kontakt 3, 4 zeigenden oberen Bereich 19 auf, in welchem jeweils eine Durchgangsöffnung 6, 7 zur Aufnahme eines Sicherungselements 7 angeordnet ist. Senkrecht zur Haupterstreckungsrichtung von diesem oberen Bereich 19 verlaufen die Kontakte 3, 4 bis zum Ende der Platine 2 parallel zueinander. Dabei ist der Abstand zwischen den Kontakten 3, 4 im oberen Bereich 19 geringer, als an den parallel zueinander verlaufenden Bereichen. Die geometrische Ausformung sowohl der Platine 2 als auch der elektrischen Kontakte 3, 4 ist lediglich beispielhaft gewählt und dient der Erläuterung der Erfindung.

Es versteht sich, dass jede andere geometrische Form für die Platine 2 und die Kontakte 3, 4 gewählt werden kann. Ferner kann die Platine 2 z.B. Aufnahmen für ein männliches oder weibliches Stecker-Element (nicht dargestellt) aufweisen, welches elektrisch mit den Kontakten 3, 4 gekoppelt sein kann.

In Fig. 9 ist ferner gestrichelt angedeutet, dass der obere Bereich 19 der Kontakte 3, 4 vergrößert sein kann. Die elektrischen Kontakte 3, 4 können dort weitere Durchgangsöffnungen für weitere Sicherungselemente aufweisen (ebenfalls gestichelt dargestellt). Diese werden durch die gezeigte Anordnung dann elektrisch parallel geschaltet.

In jede der Durchgangsöffnungen 6, 7 ist ein Ende eines Sicherungselements 7 eingeführt, welches mit dem jeweiligen Kontakt 3, 4 elektrisch und mechanisch verbunden ist. Eine solche Verbindung kann z.B. durch Löten oder Kleben hergestellt werden.

Das Sicherungselement 7 selbst ist als eine Art Drahtbrücke aus Zinn oder einer Zinnlegierung ausgebildet. Das Sicherungselement 7 weist ein Sicherungsmaterial (siehe Figuren 2 und 3) auf, das in direktem Kontakt mit einem Schmelzmittel (siehe Figuren 2 und 3), insbesondere einem Flussmittel, steht. Dabei liegt der Schmelzpunkt des Schmelzmittels unter dem des Sicherungsmaterials.

Wird die Sicherungsvorrichtung 1 nun in einem Strompfad angeordnet, bildet einer der Kontakte 3, 4 den Eingang der Sicherungsvorrichtung 1 und der andere Kontakt 3, 4 den Ausgang der Sicherungsvorrichtung 1. Wie bereits erwähnt, kann dazu z.B. ein entsprechender Stecker an der Platine 2 vorgesehen werden. Alternativ kann die Sicherungsvorrichtung 1 auch als Bestandteil einer größeren Platine in einem Gerät, z.B. einem Steuergerät eines Automobils oder eines anderen Fahrzeugs, integriert sein.

Fließt nun ein Strom über den ersten Kontakt 3, das Sicherungselement 7 und den zweiten Kontakt 4, erwärmt sich insbesondere das Sicherungselement 7. Das Sicherungselement 7 ist dabei derart dimensioniert, dass es bei einem Überstrom schmilzt, bevor die durch die Sicherungsvorrichtung 1 zu schützenden Elemente Schaden nehmen. Es schmilzt also, bevor in den zu schützenden Elementen der Überstrom Zerstörungen hervorruft.

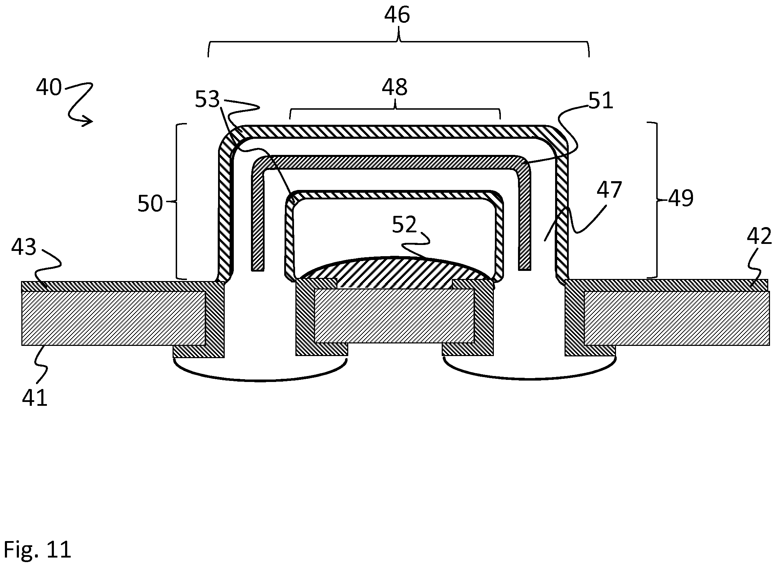

Wird die Sicherungsvorrichtung 1 nicht verkapselt, steht das Sicherungselement 7 in Kontakt mit der Umgebungsluft und damit auch Sauerstoff. Durch den Sauerstoff bildet sich eine Oxidschicht (siehe Fig. 11) auf der Oberfläche des Sicherungselements 7. Wie oben bereits erläutert, kann diese das Ansprechverhalten der Sicherungsvorrichtung 1 verändern und ist daher unerwünscht. Die Oxidschicht wird bei dem Sicherungselement 7 aber durch das Schmelzmittel zerstört, sobald die Temperatur als Katalysator für die notwendige Reaktion hoch genug ist. Damit wird das Sicherungselement 7 bei entsprechenden Temperaturen von der Oxidschicht befreit und behält die gewünschte Auslösecharakteristik bei.

In Fig. 9 ist das Sicherungselement 7 als eine Drahtbrücke ausgebildet, die durch die Durchgangsöffnungen geschoben und dort befestigt wird. Es versteht sich aber, dass jede andere Art von Sicherungselement 7 genutzt werden kann. Beispielswiese kann das Sicherungselement 7 auch streifenförmig ausgebildet sein. Die Enden des Streifens können dann z.B. mit den elektrischen Kontakten 3, 4 verklebt oder mittels Durchsetzfügen verbunden werden.

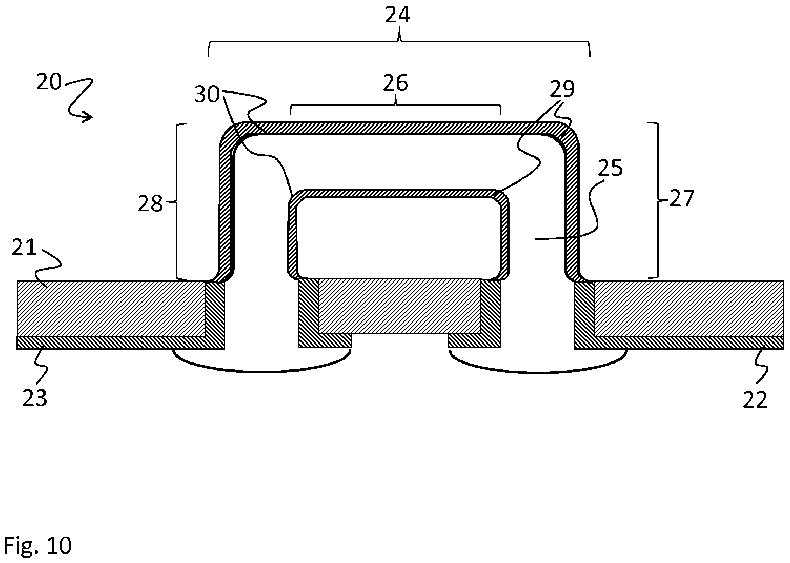

Die Schnittansicht der Fig. 10 zeigt eine mögliche Ausbildung des Sicherungselements 24, dass z.B. auf der Platine 21 eingesetzt werden kann. Für den Sicherungsträger 21 der Fig. 10 gelten die Erläuterungen zu dem Sicherungsträger 2 der Fig. 9.

Das Sicherungselement 24 ist brückenartig ausgebildet und weist einen frei schweben-den Sicherungsabschnitt 26 auf, der von zwei Lagern 27, 28 getragen wird. Der Winkel zwischen dem frei schwebenden Sicherungsabschnitt 26 und den Lagern 27, 28 beträgt ca. 90°. Es versteht sich, dass dieser Winkel lediglich beispielhaft gewählt ist. Das Sicherungselement 24 könnte z.B. auch halbkreisartig ausgebildet sein.

Der Sicherungsträger 21 ist ebenfalls als Platine ausgebildet. Die elektrischen Kontakte 22 und 23 sind auf der Seite des Sicherungsträgers 21 angeordnet, die dem Sicherungselement 24 gegenüberliegt. Die Enden der Lager 27, 28 sind durch die Durchgangsöffnungen (nicht separat bezeichnet) geführt und auf der Seite der elektrischen Kontakte 22, 23 jeweils mit dem entsprechenden Kontakt 22, 23 verlötet.

Das Sicherungselement 24 besteht hauptsächlich aus Sicherungsmaterial 25. Auf der den elektrischen Kontakten 22, 23 gegenüberliegenden Seite des Sicherungsträgers 21 ist das Sicherungselement 24 mit einer Schicht aus Schmelzmittel 29 überzogen, die also auf dessen Oberfläche angeordnet ist. In der Darstellung der Fig. 10 reicht das Schmelzmittel 29 bis auf die Oberfläche des Sicherungsträgers 21. Das Sicherungselement 24 ist also vollständig von dem Schmelzmittel 29 bedeckt. Das Schmelzmittel 29 kann z.B. in einem Tauchbad oder durch aufsprühen aufgebracht werden.

Erhitzt sich nun das Sicherungsmaterial 25 z.B. auf Grund eines Überstroms, verflüssigt sich auf Grund des geringeren Schmelzpunktes zuerst das Schmelzmittel und zersetzt eine mögliche Oxidschicht (siehe Fig. 11) auf der Oberfläche des Sicherungselements 24. Ferner schützt die Schicht aus Schmelzmittel 29 selbst die Oberfläche 30 des Sicherungselements 24 auch vor direktem Kontakt mit Sauerstoff und verringert so die Oxidbildung.

Die durch die Durchgangsöffnungen hindurchgeführten Enden der Lager 27, 28 sind direkt auf den Durchgangsöffnungen verlötet. Es versteht sich, dass die Enden der Lager 27, 28 z.B. auch abgeknickt werden können und an anderen Stellen mit den Kontakten 22, 23 verlötet werden können.

Die Schnittansicht der Fig. 11 zeigt eine weitere mögliche Ausbildung des Sicherungselements 46, dass z.B. auf der Platine 41 eingesetzt werden kann. Für den Sicherungsträger 41 der Fig. 11 gelten die Erläuterungen zu dem Sicherungsträger 2 der Fig. 9.

Im Gegensatz zu dem Sicherungsträger 21 der Fig. 10 sind bei dem Sicherungsträger 41 die elektrischen Kontakte 42, 43 auf derjenigen Seite angeordnet, auf der auch das Sicherungselement 46 angeordnet ist. Die Kontakte 42, 43 erstrecken sich durch die Durchgangsöffnungen hindurch auf die Rückseite des Sicherungsträgers 41, auf welcher sie mit dem Sicherungselement 46 verlötet sind. Solche Durchgangsöffnungen werden auch Durchkontaktierungen oder Vias genannt. Es versteht sich, dass die Details der Figuren 2 und 3 bezüglich der Anordnung der elektrischen Kontakte 22, 23, 42, 43 beliebig miteinander kombiniert werden können. Die elektrischen Kontakte 42, 43 könnten folglich auch auf der Unterseite des Sicherungsträgers 41 angeordnet sein.

Die Geometrie des Sicherungselements 46 gleicht der Geometrie des Sicherungselements 24 der Fig. 10. Es weist also einen frei schwebenden Sicherungsabschnitt 48 und zwei Lager 49, 50 auf.

Unter dem frei schwebenden Sicherungsabschnitt 48 ist eine Schicht aus Isolationsmaterial 52 angeordnet. Das Isolationsmaterial 52 bedeckt die Enden der zwei Kontakte 42, 43, die unter dem frei schwebenden Sicherungsabschnitt 48 liegen. Das Isolationsmaterial 52 verhindert, dass herunter tropfendes Sicherungsmaterial 47 einen elektrischen Kontakt zwischen den zwei Kontakten 42, 43 herstellt. Selbstverständlich kann das Isolationsmaterial 52 auch z.B. bei der Anordnung der Fig. 10 genutzt werden und/oder auch größere Teile der elektrischen Kontakte 42, 43 bedecken.

Im Gegensatz zu Fig. 10 ist das Schmelzmittel bei dem Sicherungselement 46 nicht auf dessen Oberfläche angeordnet. Vielmehr ist das Schmelzmittel 51 bei dem Sicherungselement 46 in dessen Innerem angeordnet. Das Sicherungselement 46 weist also eine Seele aus Schmelzmittel 51 in seinem Inneren auf. Auf seiner Außenseite hat sich daher eine Oxidschicht 53 gebildet.

Erhitzt sich das Sicherungselement 46 auf Grund eines Überstroms, verflüssigt sich das Schmelzmittel 51. Es kann z.B. auch dazu kommen, dass das Schmelzmittel 51 bereits seinen Siedepunkt erreicht, bevor das Sicherungsmaterial 47 sich vollständig verflüssigt. Die Blasenbildung in dem Schmelzmittel 51 unterstützt dann mechanisch die Zerstörung des Sicherungselements 46. Aber auch ohne die Blasenbildung kommt das Schmelzmittel 51 mit der Oxidschicht 53 in Kontakt, sobald sich das Sicherungsmaterial 47 verflüssigt. Bei Kontakt mit der Oxidschicht 53 zerstört das Schmelzmittel 51 diese und das Sicherungsmaterial 47 kann abfließen.

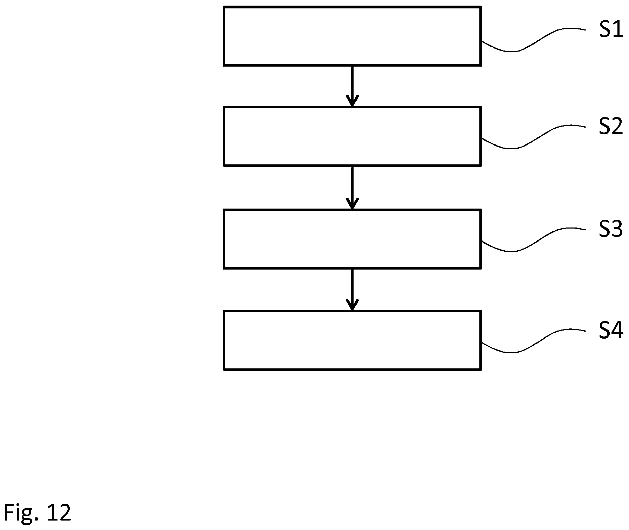

Fig. 12 zeigt ein Ablaufdiagramm eines Herstellverfahrens zum Herstellen einer elektrischen Sicherungsvorrichtung 1, 20, 40 gemäß einem Ausführungsbeispiel der vorliegen-den Erfindung. Zum leichteren Verständnis werden in der folgenden Beschreibung die Bezugszeichen zu den Figuren 1-3 als Referenz beibehalten.

In einem ersten Schritt S1 des Bereitstellens wird ein elektrisch isolierender Sicherungs-träger 2, 21, 41 bereitgestellt. In einem Schritt S2 des Anordnens wird ein erster elektrischer Kontakt 3, 22, 42 auf dem Sicherungsträger 2, 21, 41 angebracht. Ein zweiter elektrischer Kontakt 4, 23, 43 wird in Schritt S3 auf dem Sicherungsträger 2, 21, 41 elektrisch isoliert von dem ersten elektrischen Kontakt 3, 22, 42 angeordnet. Schließlich wird in einem Schritt S4 des elektrischen Koppelns eine Anzahl von Sicherungselementen 8, 24, 46 mit dem ersten elektrischen Kontakt 3, 22, 42 und dem zweiten elektrischen Kontakt 4, 23, 43 gekoppelt. Dabei weisen die Sicherungselemente 8, 24, 46 ein elektrisch leitendes Sicherungsmaterial 25, 47 mit einer vorgegebenen Strombelastbarkeit und ein Schmelzmittel 29, 51 in Kontakt mit dem Sicherungsmaterial 25, 47 auf. Das Schmelzmittel 29, 51 hat ferner einen niedrigeren Schmelzpunkt, als das Sicherungsmaterial 25, 47.

Die Sicherungselemente 8, 24, 46 können z.B. als brückenartige Sicherungselemente 8, 24, 46 bereitgestellt werden, die jeweils einen frei schwebenden Sicherungsabschnitt 26, 48 und an den Enden des Sicherungsabschnitts 26, 48 jeweils ein Lager 27, 28, 49, 50 aufweisen. Solche Sicherungselemente 8, 24, 46 können sehr einfach verbaut werden. Beispielsweise kann eines der Lager 27, 28, 49, 50 mit dem ersten elektrischen Kontakt 3, 22, 42 und eines der Lager 27, 28, 49, 50 mit dem zweiten elektrischen Kontakt 4, 23, 43 elektrisch gekoppelt werden.

In dem Sicherungsträger 2, 21, 41 kann an jedem der elektrischen Kontakte 3, 22, 42, 4, 23, 43 für jedes der Sicherungselemente 8, 24, 46 eine Durchgangsöffnung 6, 7 angeordnet werden. Ferner kann jeweils ein Ende eines entsprechenden der Sicherungselemente 8, 24, 46 durch die entsprechende Durchgangsöffnung 6, 7 geführt werden und mit dem jeweiligen elektrischen Kontakt 3, 22, 42, 4, 23, 43 verlötet werden.

Das Schmelzmittel 29, 51 kann auf unterschiedliche Arten bereitgestellt werden. Beispielsweise kann das Schmelzmittel 29, 51 auf der Außenseite 30 des Sicherungsmaterials 25, 47 aufgebracht werden. Zusätzlich oder alternativ kann das Schmelzmittel 29, 51 auch im Inneren des Sicherungsmaterials 25, 47 angeordnet werden.

Als Sicherungsmaterial 25, 47 wird Zinn oder eine Zinnlegierung genutzt.

Um Kurzschlüsse der elektrischen Kontakte zu vermeiden, kann ein Isolationsmaterial 52 bereitgestellt werden, das mindestens einen der elektrischen Kontakte 3, 22, 42, 4, 23, 43 zumindest teilweise bedeckt.

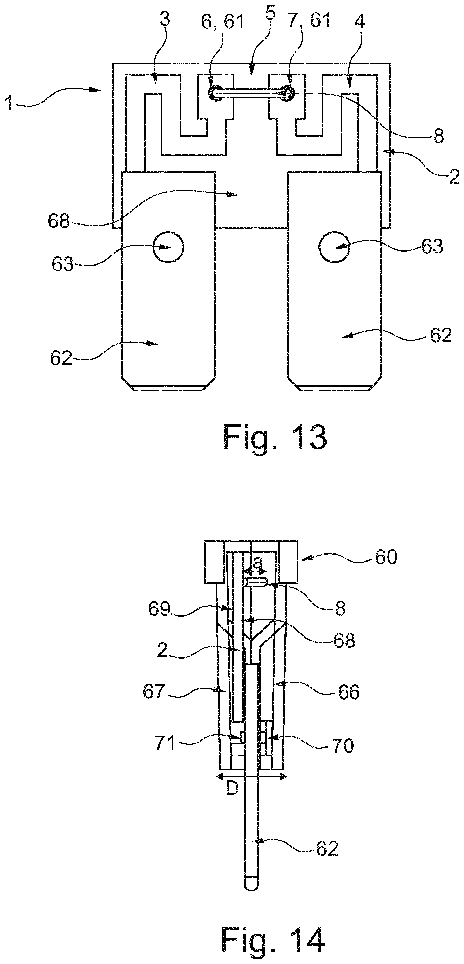

In Figur 13 ist der Aufbau einer Sicherungsvorrichtung 1 dargestellt. Bekannt ist beispielsweise eine Sicherung in einem außengeometrisch, beispielsweise nach ISO 8820-3, genormten Gehäuse, welches einen durch die Norm festgelegten und streng begrenzten Gehäusebauraum bedeutet. Wenn der bügelförmige Draht 8 mit einer Gehäuseinnenwand kollidiert, würde die Auslösecharakteristik der Sicherung negativ beeinflusst werden. Um eine Kollision mit dem Gehäuse zu vermeiden, müsste der Träger 2 asymmetrisch im Gehäuse platziert werden. Dies ist jedoch nicht möglich, da es eine nicht zentrische Lage bezüglich einer Gehäusedicke D der Kontaktfüßchen mit sich bringen würde, was auf Grund der Vorgaben der Norm nicht zulässig ist. Die in Fig. 13 gezeigte Sicherungsvorrichtung 1 behebt dieses Problem. Die Sicherungsvorrichtung 1 besteht aus einem plattenförmigen, elektrisch isolierenden Träger 2 aus Keramik oder einem herkömmlichem Leiterplattenmaterial, wie beispielsweise FR4, und zwei auf den Träger 2 aufgebrachten und um einen Spalt 5 voneinander beabstandeten Leiterbahnen 3, 4 aus Kupfer. Zur Überbrückung des Spalts 5 ist ein bügelförmiger Draht 8 von einer hier gezeigten ersten Seite 68 des Trägers 2 in Durchkontaktierungen 61 gesteckt und auf der nicht gezeigten, der ersten Seite 68 gegenüberliegenden, zweiten Seite 69 mit den Durchkontaktierungen 61 verlötet. Der bügelförmige Draht 8 besteht aus einem niedrigschmelzenden Metall, erfindungsgemäß aus Zinn oder einer Zinnlegierung.

Die erwähnten aus Trägermaterial gebildeten Kontaktfüßchen sind nicht mehr vorgesehen. Sie sind durch ausgestanzte Kontaktbleche 62 ersetzt. Durch das Austanzen können die Kontaktbleche 62 sehr einfach mit den durch die Norm vorgegebenen Maßen gefertigt werden. Die Kontaktbleche 62 sind auf der ersten Seite 68 des Trägers 2 aufgebracht und mit den Leiterbahnen 3, 4 verlötet.

In der, in Figur 13 gezeigten Ausgestaltung, ist der Drahtbügel 8 in der Nähe eines Seitenrands des Trägers 2, der den Kontaktblechen 62 gegenüberliegt, durch den Träger 2 gesteckt und parallel zu diesem Seitenrand ausgerichtet. Dadurch ergibt sich auf dem Träger 2 möglichst viel Fläche, insbesondere zwischen den Kontaktblechen 62 und dem Drahtbügel 8, sodass die Ausgestaltung der Leiterbahnen 3, 4 individuell an die Auslösecharakteristik angepasst werden kann. In diesem Fall sind die beiden Leiterbahnen 3, 4 in einer Mäanderform auf den Träger 2 aufgebracht und symmetrisch zueinander ausgebildet. Die Ausgestaltung der Leiterbahnen 3, 4 kann jedoch je nach Anforderungen an die Auslösecharakteristik der Sicherungsvorrichtung 1 in Form, Länge und Querschnittsfläche variieren.

Weiterhin ist in Figur 13 zu erkennen, dass beide Kontaktbleche 62 jeweils ein Durchgangsloch 63 aufweisen. Diese werden beim Ausstanzen der Kontaktbleche 62 mit in die Kontaktbleche 62 eingebracht. Die Durchgangslöcher 63 dienen im Zusammenspiel mit dem Gehäuse 60 als Zugentlastung, um die Lötstelle nicht mechanisch zu belasten. Gemäß der Norm ISO 8820-3 müssen die Kontaktbleche 62 in Zug- und Druckrichtung zum Gehäuse je nach Sicherungstyp Kräften von 50 N bis 90 N standhalten.

Eine solche Sicherungsvorrichtung 1 ist nun, wie in Figur 14 gezeigt, asymmetrisch im Gehäuse 60 platziert, während die Kontaktbleche 62 bezüglich der Dicke D des Gehäuses 60 zentriert angeordnet sind. Für den bügelförmigen Draht 8 ergibt sich auf diese Weise genug Raum im Gehäuseinneren, sodass eine Kollision des Drahtbügels 8 mit der der ersten Seite 68 des Trägers 2 zugewandten Gehäuseinnenwand vermieden wird.

Anhand von Figur 14 ist gut zu erkennen, wie der durch die Norm limitiere Gehäuseinnenraum für die Unterbringung der Sicherungsvorrichtung 1 optimal ausgenutzt wird und der Drahtbügel 8 beabstandet zu einer diesem zugewandten Innenwand des Gehäuses 60 untergebracht ist. Das Gehäuse 60 besteht aus zwei identischen Gehäusehälften 66, 67. Die erste Gehäusehälfte 66 (hier rechts) bildet benachbart zu der ersten Seite 68 des Trägers 2 einen Hohlraum für den Drahtbügel 8 aus, während der Träger 2 in der zweiten Gehäusehälfte 67 (hier links) angeordnet ist. Da die Gehäusehälften 66, 67 identisch ausgebildet sind, ist der Bauraum, der für die Aufnahme des Trägers 2 ausgestaltet ist, gleichzeitig die Aussparung der ersten Gehäusehälfte 66, die verhindert, dass der Drahtbügel 8 mit der Gehäuseinnenwand kollidiert. In diesem Ausführungsbeispiel sind die Kontaktbleche 62 eben ausgeführt. Für einen Abstand a zwischen Träger 2 und äußerem Scheitelpunkt des Drahtbügels 8 steht damit auf jeden Fall die gleiche Platzmenge zur Verfügung wie durch eine Dicke des Trägers 2 mit den aufgebrachten Kontaktblechen 62 eingenommen wird. Um eine Kollision des Drahtbügels 8 mit der Gehäuseinnenwand zu verhindern, sollte der Abstand a daher kleiner als die Dicke d gewählt werden. Damit ist der Scheitpunkt des Drahtbügels 8 von der Gehäuseinnenwand beabstandet.

Für den Fall, dass auf der ersten Seite 68 und der zweiten Seite 69 des Trägers 2 im Wesentlichen deckungsgleiche Leiterbahnen 3, 4 aufgebracht sind, sollte der Träger 2, wie in Fig. 14 dargestellt, nicht direkt mit der zweiten Seite 69 an der Gehäuseinnenwand der zweiten Gehäusehälfte 67 anliegen, da dies die Auslösecharakteristik der Sicherungsvorrichtung 1 ebenfalls negativ beeinflussen könnte. In diesem Fall kann der Abstand a auch gleich der Dicke d gewählt werden.

An der ersten Gehäusehälfte 66 ist ein Zapfen 70 angeordnet, der zum Ausbilden der oben erwähnten Zugentlastung in das in Fig. 13 dargestellte Durchgangsloch 63 des Kontaktblechs 62 eingreift und bei vollständig montiertem Gehäuse in einer Aufnahme 71 der zweiten Gehäusehälfte 67 steckt. Da die Gehäusehälften 66, 67 identisch ausgebildet sind, ist ein entsprechender zweiter Zapfen (nicht dargestellt), der ein zweites Kontaktblech 62 durchdringt an der zweiten Gehäusehälfte 67 angeordnet und die Aufnahme für den zweiten Zapfen an der ersten Gehäusehälfte 66.

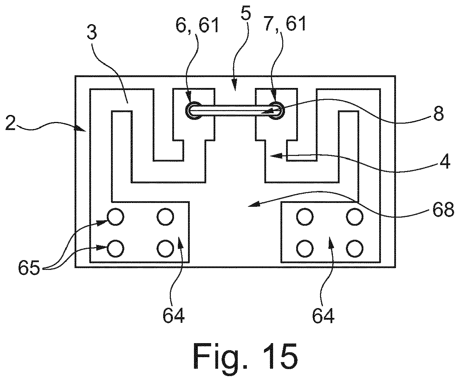

Figur 15 zeigt vorteilhafte Ausgestaltungen des plattenförmigen, elektrisch isolierenden Trägers 2. Zur Verdeutlichung sind die in Figur 13 aufgelöteten Kontaktbleche 62 hier nicht dargestellt. Die beiden Leiterbahnen 3, 4 bilden jeweils eine Kontaktzone 64 aus. Die Kontaktzone 64 ist in ihrer geometrischen Form und Größe an die der Kontaktbleche 62 angepasst. Die Kontaktbleche 62 werden dann auf diese Kontaktzonen 64 aufgelötet.

Weiter ist in Figur 15 gezeigt, dass in der Kontaktzone 64 weitere Durchkontaktierungen 65 vorgesehen sind. Mittels der Durchkontaktierungen 65 lässt sich ein elektrischer Kontakt von der zweiten Seite 69 des Trägers 2 mit einer auf der ersten Seite 68 aufgebrachten Leiterbahn 3, 4 herstellen. Alternativ kann hierdurch auch eine Verbindung zwischen den im Wesentlichen deckungsgleich auf der ersten 68 und der zweiten Seite 69 auf den Träger 2 aufgebrachte Leiterbahnen 3, 4 hergestellt werden.

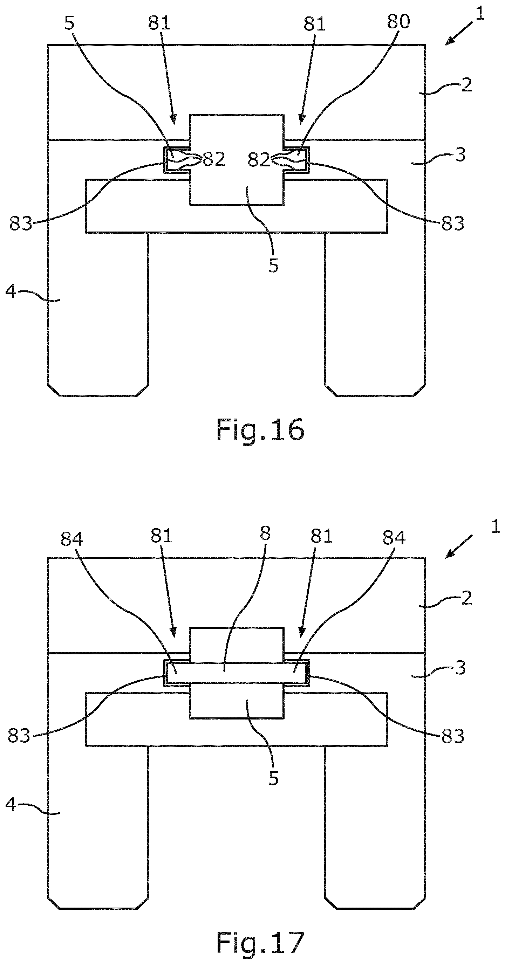

Eine Sicherungsvorrichtung 1 ist in einer Draufsicht in Fig. 16 gezeigt. Die vorliegend dargestellte Sicherungsvorrichtung 1 ist noch nicht vollständig fertiggestellt. Die Sicherungsvorrichtung 1 umfasst im vorliegend gezeigten Fall zwei aus Kupfer hergestellte Leiterbahnen 3, 4, die auf einem Trägerelement 2 angeordnet sind. Bei dem Trägerelement 2 handelt es sich mit anderen Worten also um eine Art Platine, auf welcher die beiden Leiterbahnen 3, 4 hergestellt worden sind. Zur Herstellung der Leiterbahnen 3, 4 kann beispielsweise zunächst das gesamte Trägerelement 2 mit einer dünnen Kupferschicht versehen werden, wobei anschließend das aufgebrachte Kupfer derart weggeätzt wird, dass nur noch die beiden Leiterbahnen 3, 4 auf dem Trägerelement 2 verbleiben.

Eine als Aussparung oder Freiraum 5 dienende Durchgangsöffnung wird im Trägerelement 2 hergestellt, beispielsweise indem entsprechendes Trägerelementmaterial aus dem Trägerelement 2 herausgestanzt oder anderweitig herausgetrennt wird. Im selben oder in einem separaten Herstellschritt werden als Durchgangsöffnungen ausgebildete Aussparungen 80 an jeweiligen einander zugewandten Leiterbahnendabschnitten 81 und dem darunter angeordneten Trägerelement 2 hergestellt. Durchgangsöffnung bedeutet dabei, dass der Freiraum 5 und die Aussparungen 80 sich vollständig in Querrichtung der Sicherungsvorrichtung 1, also entsprechend der vorliegenden Darstellung senkrecht in die Beobachtungsebene hinein, durch diese hindurch erstrecken. Die Aussparungen 80 sind bezogen auf die Hauptstreckungsebene der Sicherungsvorrichtung 1 nur halboffen ausgebildet. Die Aussparungen 80 können beispielsweise ebenfalls aus den Leiterbahnen 3, 4 und dem Trägerelement 2 im Bereich der Leiterbahnendabschnitte 81 herausgestanzt oder anderweitig herausgetrennt werden.

Wie zu erkennen, sind die Aussparungen 80 im Wesentlichen U-förmig ausgebildet, wobei jeweilige Seiten 82, bei welchen es sich also um entsprechende Wandungen im Bereich der Aussparungen 80 sowohl an den Leiterbahnen 3, 4 als auch an dem darunter angeordneten Trägerelement 2 handelt, mit einer metallischen Beschichtung 83 aus Kupfer versehen sind. Bei der metallischen Beschichtung 83 handelt es sich mit anderen Worten also um eine Art Kantenmetallisierung aus Kupfer.

In Fig. 17 ist die Sicherungsvorrichtung 1 in einer weiteren Draufsicht gezeigt, wobei im vorliegend gezeigten Fall ein Schmelzleiter 8, welcher Teil der Sicherungsvorrichtung 1 ist, in die Aussparungen 80 eingepresst worden ist. Die als Einfassungen für den Schmelzleiter 8 dienenden Aussparungen 80 im Bereich der einander zugewandten Leiterbahnendabschnitte 81 werden dabei als Presspassungen dimensioniert. Das heißt, dass die Aussparungen 80 also enger dimensioniert sind als jeweilige Längsenden 84 des Schmelzleiters 8, welche in die Aussparungen 80 eingesetzt werden. Die Längsenden 84 des Schmelzleiters 8 werden zunächst oberhalb von den Aussparungen 80 positioniert und dann mit einem hier nicht dargestellten Stempel in die Aussparungen 80 hineingepresst. Dadurch, dass die Längsenden 84 breiter sind als die Aussparungen 80 werden die Längsenden 84 während des Einpressvorgangs in die Aussparungen 80 kaltverformt und dadurch zumindest im Wesentlichen bündig an jeweils an den drei Seiten 82, genauer an die aus Kupfer hergestellte metallische Beschichtung 83 der Aussparungen 80 angelegt.

Wie zu erkennen, wird der Schmelzleiter 8 dabei flach in den Aussparungen 80 angeordnet, also plan in die Aussparungen 80 eingesetzt. Die Längsenden 84 des Schmelzleiters 8 werden so tief in den Aussparungen 80 versenkt angeordnet, dass der Schmelzleiter 8 die aus den Leiterbahnen 3, 4 und dem Trägerelement 2 ausgebildete Leiterplatte in Querrichtung der Leiterplatte, also in der vorliegenden Darstellung senkrecht in die Betrachtungsebenen hinein, nicht überragt. Mit anderen Worten wird der Schmelzleiter 8 so weit in die Aussparungen 80 hineingedrückt bzw. hineingepresst, dass der Schmelzleiter 8 in Querrichtung zumindest bündig mit den Leiterbahnen 3, 4 abschließt oder sogar noch etwas versenkt in Bezug auf die Leiterbahnen 3, 4 angeordnet ist. Dabei wird der Schmelzleiter 8 vorzugsweise so mit seinen Längsenden 84 in die Aussparungen 80 hineingepresst, sodass der Schmelzleiter 8 danach weiterhin gerade und nicht etwa gekrümmt ist. In Querrichtung der Sicherungsvorrichtung 1 weist der Schmelzleiter 8 also auch nach dem Einpressen der Längsenden 84 eine gerade Form auf und beeinflusst somit die Abmessungen der Sicherungsvorrichtung 1 in Querrichtung nicht weiter. Die Dimensionen der Sicherungsvorrichtung 1 in Querrichtung werden also nicht durch den eingebrachten Schmelzleiter 8 beeinflusst. Dadurch kann eine besonders kompakte Bauweise der Sicherungsvorrichtung 1 in Querrichtung realisiert werden.

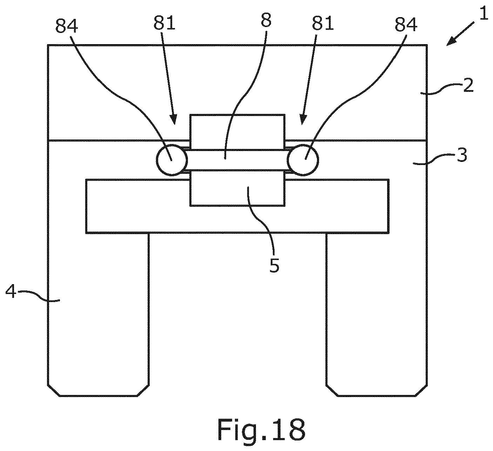

In Fig. 18 ist die Sicherungsvorrichtung 1 in einer weiteren Draufsicht gezeigt, wobei die Längsenden 84 des Schmelzleiters 8 aufgeschmolzen worden sind. Nachdem die Längsenden 84 des Schmelzleiters 8 in die Aussparungen 80 hineingepresst worden sind, werden die von den Aussparungen 80 bzw. von der metallischen Beschichtung 83 umschlossenen Längsenden 84 des Schmelzleiters 8 aufgeschmolzen und dadurch stoffschlüssig mit den Leiterbahnendabschnitten 81 verbunden. Dabei werden die Längsenden 84 stoffschlüssig mit der gesamten metallischen Beschichtung 83, welche im Bereich der Aussparungen 83 hergestellt worden ist, verbunden.

Zum Aufschmelzen des Schmelzleiters 8, genauer zum Aufschmelzen der Längsenden 84 des Schmelzleiters 8, wird der Schmelzleiter 8 nicht direkt sondern nur indirekt erwärmt, indem Wärme in die Leiterbahnen 3, 4 eingebracht wird. Der aus Zinn hergestellte Schmelzleiter 8 weist einen wesentlich niedrigeren Schmelzpunkt als die aus Kupfer hergestellten Leiterbahnen 3, 4 auf. Daher wäre eine direkte Wärmeeinbringung in den Schmelzleiter 8 nur schwer so steuerbar, dass der Schmelzleiter 8 nur an seinen Längsenden 84 anschmilzt aber der Schmelzleiter 8 dabei nicht vollständig durchschmilzt.

Um diesem Problem zu entgegnen, ist es daher vorgesehen, dass die zum Aufschmelzen der Längsenden 84 des Schmelzleiters 8 erforderliche Wärmeenergie durch Wärmeeinbringung in die Leiterbahnen 3, 4 bereitgestellt wird. Dafür wird dicht neben dem Schmelzleiter 8, also dicht an den Längsenden 84 im Bereich der Leiterbahnen 3, 4 Wärme eingebracht, und zwar so dosiert, dass der Schmelzleiter 8 im Bereich seiner Längsenden 84 zwar anschmilzt aber der Schmelzleiter 8 nicht vollständig durchschmilzt. Zur Einbringung der Wärmeenergie kann beispielsweise eine Art als Stempel ausgebildeter Lötkolben verwendet werden, der auf die Leiterbahnen 3, 4 aufgesetzt wird. Alternativ ist es auch möglich, beispielsweise einen Laser zu verwenden, mittels welchem jeweilige Laserstrahlen auf die beiden Leiterbahnen 3, 4 in der Nähe der Längsenden 84 des Schmelzleiters 8 gerichtet werden. Der Ort der Wärmeeinbringung kann beispielsweise 1 bis 3 cm von den Längsenden 84 beabstandet sein. Insbesondere bei der Verwendung eines Lasers ist die üblicherweise matte Oberfläche der Leiterbahnen, da diese aus Kupfer hergestellt sind, von Vorteil. Insgesamt wird also durch die indirekte Erwärmung der Längsenden 84 des Schmelzleiters 8 eine besonders kontrollierte Wärmeeinbringung in den Schmelzleiter 8 und somit ein besonders dosiertes und kontrolliertes Aufschmelzen der Längsenden 84 ermöglicht, sodass die Längsenden 84 zuverlässig mit den Leiterbahnen 3, 4 stoffschlüssig verbunden werden können.

Bei der hier gezeigten Sicherungsvorrichtung 1 handelt es sich um eine sogenannte Schmelzsicherung, wobei bei einer ausreichenden Stromstärke über eine entsprechende Dauer der Schmelzleiter 8 aufschmilzt und dadurch die Sicherungsvorrichtung 1 auslöst. Die Sicherungsvorrichtung 1 weist noch ein hier nicht dargestelltes Gehäuse auf, welches das Trägerelement 2 und die Leiterbahnen 3, 4 von außen umschließt. Die Sicherungsvorrichtung 1 kann beispielsweise in einem Kfz-Bordnetz eingesetzt werden, wobei die Sicherungsvorrichtung 1 zum Beispiel mit Leitungen des Kfz-Bordnetzes kontaktiert wird, um diese vor thermischer Überlastung zu schützen.

Dadurch dass der Schmelzleiter 8 plan, also flach in die länglichen metallisierten Aussparungen 80 des als Platine dienenden Trägerelements 2 eingelötet wird, hat der Schmelzleiter 8 in Kombination mit der als Freiraum 5 dienenden Durchgangsöffnung genügend Platz, um entsprechend notwendige Mindestabstände zum Trägerelement 2 und dem hier nicht dargestellten Gehäuse der Sicherungsvorrichtung 1 einzuhalten. Während des Einsatzes der Sicherungsvorrichtung 1 kann der Schmelzleiter 8 dadurch in jeder Raumlage frei durchhängen und dann durch den Einfluss der Schwerkraft abreißen, ohne das Trägerelement 2 zu berühren.

Aufgrund der beschriebenen Anordnung des Schmelzleiters 8 kann sichergestellt wer-den, dass eine entsprechende Wärmeabgabe vom Schmelzleiter 8 weder in das Trägerelement 2 noch in das hier nicht dargestellte Gehäuse der Sicherungsvorrichtung 1 zu groß wird, da entsprechend notwendige Mindestabstände eingehalten werden können. Durch die Anordnung des Schmelzleiters 8 wird also einer Zerstörung des Gehäusematerials und des Platinenmaterials des Trägerelements 2 durch Hitzeeinwirkung entgegengewirkt. Ferner kann eine wunschgemäße Auslösekennlinie des Schmelzleiters 8 und somit der Sicherungsvorrichtung 1 aufgrund der beschriebenen Anordnung des Schmelzleiters 8 besonders zuverlässig sichergestellt werden.

Da es sich bei der vorhergehend detailliert beschriebenen Vorrichtungen und Verfahren um Ausführungsbeispiele handelt, können sie in üblicher Weise vom Fachmann in einem weiten Umfang modifiziert werden, ohne den Bereich der Erfindung zu verlassen. Insbesondere sind die mechanischen Anordnungen und die Größenverhältnisse der einzelnen Elemente zueinander lediglich beispielhaft.

### BEZUGSZEICHENLISTE

- 1, 20, 40: (elektrische) Sicherungsvorrichtung, Sicherungseinrichtung
- 2, 21, 41: Sicherungsträger, Träger
- 3, 22, 42: erste Leiterbahn, erster elektrischer Kontakt
- 4, 23, 43: zweite Leiterbahn, zweiter elektrischer Kontakt
- 5: Spalt, Freiraum
- 6: erste Durchgangsöffnung
- 7: zweite Durchgangsöffnung
- 8, 24, 46: Draht, Sicherungselement, Schmelzleiter
- 9: Beschichtung
- 10: Lötfläche
- 11: Sollbruchstelle
- 12: Durchbruch
- 13: Metallkörper
- 14: Verbreiterte Bereiche
- 15: Lötstopplack
- 16: Freibleibung
- 17: unterbrochener Drahtabschnitt
- 18: Elektrische Sicherungsvorrichtung
- 19: oberer Bereich
- 25, 47: Sicherungsmaterial
- 26, 48: schwebender Sicherungsabschnitt
- 27, 28, 49, 50: Lager
- 29, 51: Schmelzmittel
- 30: Außenseite

- b: Spaltbreite

- 52: Isolationsmaterial
- 53: Oxidschicht
- S1: Verfahrensschritt des Bereitstellens
- S2: Verfahrensschritt des Anordnens
- S3: Verfahrensschritt des Anordnens
- S4: Verfahrensschritt des Koppelns

- 60: Gehäuse
- 61: Durchkontaktierung
- 62: Kontaktblech
- 63: Durchgangsloch
- 64: Kontaktzone
- 65: Weitere Durchkontaktierungen
- 66: erste Gehäusehälfte
- 67: zweite Gehäusehälfte
- 68: erste Seite des Trägers
- 69: zweite Seite des Trägers
- 70: Zapfen
- 71: Aufnahme für den Zapfen

- 80: Aussparung
- 81: Leiterbahnendabschnitt
- 82: Seite
- 83: metallische Beschichtung
- 84: Längsende

- D: Dicke des Gehäuses
- a: Abstand zwischen Träger und Scheitelpunkt des Drahtbügels

## Patentansprüche

1. Elektrische Sicherungsvorrichtung (1) zum Absichern einer elektrischen Verbindung, aufweisend
a) einen elektrisch isolierenden Träger (2),
b) eine erste Leiterbahn (3) und eine zweite Leiterbahn (4), die auf dem Träger (2) aufgebracht und um einen Spalt (5) voneinander beabstandet sind,
c) eine erste Durchgangsöffnung (6) durch den Träger (2) und die erste Leiterbahn (3) und eine zweite Durchgangsöffnung (7) durch den Träger (2) und die zweite Leiterbahn (4),
d) wobei der Spalt (5) mittels eines, von einer Seite des Trägers (2) durch die Durchgangsöffnungen (6, 7) gesteckten und gebogenen Drahtes (8) aus einem niedrigschmelzenden Metall überbrückt ist,
dadurch gezennzeichnet, dass
der Draht auf der anderen Seite des Trägers aufgeschmolzen ist, und dass das niedrigschmelzende Metall des Drahtes (8) Zinn oder eine Zinnlegierung ist.

2. Sicherungsvorrichtung (1) nach Anspruch 1, wobei der Träger (2) in den Durchgangsöffnungen (6, 7) eine elektrisch leitfähige Beschichtung (9) aufweist, die mit der ersten (3) und/oder zweiten Leiterbahn (4) elektrisch leitend verbunden ist.

3. Sicherungsvorrichtung (1) nach einem der vorherigen Ansprüche, wobei eine Querschnittfläche des Drahtes (8) entlang seiner Länge variiert.

4. Sicherungsvorrichtung (1) nach einem der vorherigen Ansprüche, wobei der Träger (2) einen Durchbruch (12) im Bereich des Spalts (5) aufweist, sodass im Auslösefall das geschmolzene Metall des Drahtes (8) abfließen kann.

5. Sicherungsvorrichtung (1) nach einem der vorherigen Ansprüche, wobei der Träger (2) mehrere erste Durchgangsöffnungen (6) durch den Träger (2) und die erste Leiterbahn (3) und eine gleiche Anzahl zweiter Durchgangsöffnungen (7) durch den Träger (2) und die zweite Leiterbahn (4) aufweist und der Spalt (5) durch mehr als einen gebogenen Draht (8) überbrückt wird.

6. Sicherungsvorrichtung (1) nach einem der vorherigen Ansprüche, wobei sich auf mindestens einer der beiden Leiterbahnen (3, 4) in der Nähe des Drahtes (8), den Spalt (5) nicht überbrückend, ein Metallkörper (13) aus niedrigschmelzendem Metall befindet.

7. Sicherungsvorrichtung (1, 20, 40) nach einem der vorherigen Ansprüche, bei dem eine Anzahl von Drähten (8, 24, 46) als Sicherungselemente (8, 24, 46) ein elektrisch leitendes Sicherungsmaterial (25, 47) mit einer vorgegebenen Strombelastbarkeit und ein Schmelzmittel (29, 51) in Kontakt mit dem Sicherungsmaterial (25, 47) aufweisen, wobei das Schmelzmittel (29, 51) einen niedrigeren Schmelzpunkt aufweist, als das Sicherungsmaterial (25, 47).

8. Sicherungsvorrichtung (1, 20, 40) nach Anspruch 7, mit brückenartigen Drähten (8, 24, 46), die jeweils einen frei schwebenden Sicherungsabschnitt (26, 48) und an den Enden des Sicherungsabschnitts (26, 48) jeweils ein Lager (27, 28, 49, 50) aufweisen, wobei eines der Lager (27, 28, 49, 50) mit der ersten Leiterbahn (3, 22, 42) und eines der Lager (27, 28, 49, 50) mit der zweiten Leiterbahn (4, 23, 43) elektrisch gekoppelt ist.

9. Sicherungsvorrichtung (1, 20, 40) nach Anspruch 7, wobei der Sicherungsträger (2, 21, 41) an jedem der elektrischen Kontakte (3, 22, 42, 4, 23, 43) für jeden der Drähte (8, 24, 46) eine Durchgangsöffnung (6, 7) aufweist und jeweils ein Ende eines entsprechenden der Drähte (8, 24, 46) durch die entsprechende Durchgangsöffnung (6, 7) geführt ist und mit der jeweiligen Leiterbahn (3, 22, 42, 4, 23, 43) verlötet ist.

10. Sicherungsvorrichtung (1, 20, 40) nach einem der vorherigen Ansprüche, mit zwei Kontaktblechen (62), die auf einer ersten Seite (68) auf den Träger (2) aufgebracht und mit jeweils einer der beiden Leiterbahnen (3, 4) elektrisch leitend verbunden sind, wobei der Träger (2) derart in einem Gehäuse (60) platziert ist, dass die Kontaktbleche (62) teilweise aus dem Gehäuse (60) herausragen und bezüglich der Dicke (D) des Gehäuses (60) zentriert angeordnet sind.

11. Sicherungsvorrichtung (1, 20, 40) nach Anspruch 10, wobei das Gehäuse (60) aus zwei Gehäusehälften (66, 67) besteht, wobei eine erste Gehäusehälfte (66) einen Hohlraum für den Drahtbügel (8) und eine zweite Gehäusehälfte (67) eine Aufnahme für den Träger (2) ausbildet.

12. Sicherungsvorrichtung (1, 20, 40) nach einem der Ansprüche 10 oder 11, wobei die Kontaktbleche (62) gekröpft sind.

13. Sicherungsvorrichtung (1, 20, 40) nach einem der Ansprüche 10 bis 12, wobei wenigstens eines der beiden Kontaktbleche (62) ein Durchgangsloch (63) aufweist, das zur Zugentlastung formschlüssig in einen am Gehäuse (60) angeformten Zapfen (70) eingreift.

14. Sicherungsvorrichtung (1, 20, 40) nach einem der vorherigen Ansprüche, wobei einander zugewandte Leiterbahnendabschnitte (81) der Leiterbahnen (3, 4) sowie das darunter angeordnete Trägerelement (2) Aussparungen (80) aufweisen, welche jeweilige Längsenden (84) des Schmelzleiters (8) umschließen, sowie die Längsenden (84) des Schmelzleiters (8) im Bereich der Aussparungen (80) stoffschlüssig mit den Leiterbahnendabschnitten (81) verbunden sind.

15. Sicherungsvorrichtung (1, 20, 40) nach Anspruch 14, **dadurch gekennzeichnet, dass** die am Trägerelement (2) angeordneten Aussparungen (80) mit einer metallischen Beschichtung (83) versehen sind, mit welcher die Längsenden (84) des Schmelzleiters (8) stoffschlüssig verbunden sind.

## Claims

1. Electrical fuse apparatus (1) for protecting an electrical connection, having
a) an electrically insulating carrier (2),
b) a first conductor track (3) and a second conductor track (4) which are mounted on the carrier (2) and are spaced apart from one another by a gap (5),
c) a first passage opening (6) through the carrier (2) and the first conductor track (3), and a second passage opening (7) through the carrier (2) and the second conductor track (4),
d) wherein the gap (5) is bridged by means of a bent wire (8) which is inserted through the passage openings (6, 7) from one side of the carrier (2) and is composed of a low-melting metal,
**characterized in that**
the wire is melted on the other side of the carrier, and **in that**
the low-melting metal of the wire (8) is tin or a tin alloy.

2. Fuse apparatus (1) according to Claim 1, wherein the carrier (2) has an electrically conductive coating (9) in the passage openings (6, 7), which electrically conductive coating is electrically conductively connected to the first conductor track (3) and/or the second conductor track (4).

3. Fuse apparatus (1) according to either of the preceding claims, wherein a cross-sectional area of the wire (8) varies along its length.

4. Fuse apparatus (1) according to one of the preceding claims, wherein the carrier (2) has an aperture (12) in the region of the gap (5), so that the melted metal of the wire (8) can flow away in the event of tripping.

5. Fuse apparatus (1) according to one of the preceding claims, wherein the carrier (2) has a plurality of first passage openings (6) through the carrier (2) and the first conductor track (3), and an equal number of second passage openings (7) through the carrier (2) and the second conductor track (4), and the gap (5) is bridged by more than one bent wire (8).

6. Fuse apparatus (1) according to one of the preceding claims, wherein a metal body (13) which is composed of low-melting metal is located on at least one of the two conductor tracks (3, 4) in the vicinity of the wire (8), in a manner not bridging the gap (5).

7. Fuse apparatus (1, 20, 40) according to one of the preceding claims, in which a number of wires (8, 24, 46), as fuse elements (8, 24, 46), have an electrically conductive fuse material (25, 47) with a prespecified current-carrying capacity and a fusible agent (29, 51) in contact with the fuse material (25, 47), wherein the fusible agent (29, 51) has a lower melting point than the fuse material (25, 47).

8. Fuse apparatus (1, 20, 40) according to Claim 7, with bridge-like wires (8, 24, 46) which each have a freely floating fuse section (26, 48) and, at the ends of the fuse section (26, 48), each have a bearing (27, 28, 49, 50), wherein one of the bearings (27, 28, 49, 50) is electrically coupled to the first conductor track (3, 22, 42) and one of the bearings (27, 28, 49, 50) is electrically coupled to the second conductor track (4, 23, 43).

9. Fuse apparatus (1, 20, 40) according to Claim 7, wherein the fuse carrier (2, 21, 41) has a passage opening (6, 7) on each of the electrical contacts (3, 22, 42, 4, 23, 43) for each of the wires (8, 24, 46), and in each case one end of a corresponding one of the wires (8, 24, 46) is guided through the corresponding passage opening (6, 7) and is soldered to the respective conductor track (3, 22, 42, 4, 23, 43).

10. Fuse apparatus (1, 20, 40) according to one of the preceding claims, comprising two contact plates (62) which are mounted on a first side (68) on the carrier (2) and are electrically conductively connected to in each case one of the two conductor tracks (3, 4), wherein the carrier (2) is positioned in a housing (60) in such a way that the contact plates (62) partially protrude out of the housing (60) and are arranged in a centred manner with respect to the thickness (D) of the housing (60).

11. Fuse apparatus (1, 20, 40) according to Claim 10, wherein the housing (60) consists of two housing halves (66, 67), wherein a first housing half (66) forms a cavity for the wire clip (8), and a second housing part (67) forms a receptacle for the carrier (2).

12. Fuse apparatus (1, 20, 40) according to either of Claims 10 and 11, wherein the contact plates (62) are bent.

13. Fuse apparatus (1, 20, 40) according to one of Claims 10 to 12, wherein at least one of the two contact plates (62) has a passage hole (63) which, for strain relief, engages in an interlocking manner into a pin (70) which is integrally formed on the housing (60).

14. Fuse apparatus (1, 20, 40) according to one of the preceding claims, wherein conductor track end sections (81), which face one another, of the conductor tracks (3, 4) and also the carrier element (2) arranged therebeneath have cutouts (80) which surround respective longitudinal ends (84) of the fusible conductor (8), and also the longitudinal ends (84) of the fusible conductor (8) are cohesively connected to the conductor track end sections (81) in the region of the cutouts (80).

15. Fuse apparatus (1, 20, 40) according to Claim 14, **characterized in that** the cutouts (80) which are arranged on the carrier element (2) are provided with a metal coating (83) to which the longitudinal ends (84) of the fusible conductor (8) are cohesively connected.

## Revendications

1. Dispositif de sécurité électrique (1) destiné à sécuriser une liaison électrique, comportant
a) un support électriquement isolant (2),
b) une première piste conductrice (3) et une seconde piste conductrice (4) qui sont appliquées sur le support (2) et sont espacées l'une de l'autre par un intervalle (5),
c) une première ouverture de passage (6) à travers le support (2) et la première piste conductrice (3) et une seconde ouverture de passage (7) à travers le support (2) et la seconde piste conductrice (4),
d) dans lequel l'intervalle (5) est ponté au moyen d'un fil (8) fait d'un métal à bas point de fusion, qui est enfiché d'un côté du support (2) à travers les ouvertures de passage (6, 7) et cintré,
**caractérisé en ce que** le fil est fondu de l'autre côté du support, et **en ce que** le métal à bas point de fusion du fil (8) est de l'étain ou un alliage d'étain.

2. Dispositif de sécurité (1) selon la revendication 1, dans lequel le support (2) présente dans les ouvertures de passage (6, 7) un revêtement électriquement conducteur (9) qui est relié de manière électriquement conductrice à la première (3) et/ou à la seconde piste conductrice (4) .

3. Dispositif de sécurité (1) selon l'une des revendications précédentes, dans lequel une section transversale du fil (8) varie suivant sa longueur.

4. Dispositif de sécurité (1) selon l'une des revendications précédentes, dans lequel le support (2) présente une traversée (12) dans la zone de l'intervalle (5), de manière à ce qu'en cas de déclenchement, le métal fondu du fil (8) puisse s'écouler.

5. Dispositif de sécurité (1) selon l'une des revendications précédentes, dans lequel le support (2) présente une pluralité de premières ouvertures de passage (6) à travers le support (2) et la première piste conductrice (3) et un nombre égal de secondes ouvertures de passage (7) à travers le support (2) et la seconde piste conductrice (4), et l'intervalle (5) est ponté par plus d'un fil cintré (8).

6. Dispositif de sécurité (1) selon l'une des revendications précédentes, dans lequel un corps métallique (13) fait d'un métal à bas point de fusion est situé sur au moins l'une des deux pistes conductrices (3, 4) à proximité du fil (8), sans pontage de l'intervalle (5) .

7. Dispositif de sécurité (1, 20, 40) selon l'une des revendications précédentes, dans lequel un certain nombre de fils (8, 24, 46) comportent en tant qu'éléments de sécurité (8, 24, 46) un matériau de sécurité électriquement conducteur (25, 47) présentant une capacité de transport de courant prédéterminée et un moyen de fusion (29, 51) en contact avec le matériau de sécurité (25, 47), dans lequel le moyen de fusion (29, 51) présente un point de fusion inférieur à celui du matériau de sécurité (25, 47).

8. Dispositif de sécurité (1, 20, 40) selon la revendication 7, comprenant des fils en pont (8, 24, 46), qui présentent respectivement une section de sécurité flottant librement (26, 48) et un palier (27, 28, 49, 50) aux extrémités de la section de sécurité (26, 48), dans lequel l'un des paliers (27, 28, 49, 50) est électriquement couplé à la première piste conductrice (3, 22, 42) et l'un des paliers (27, 28, 49, 50) est électriquement couplé à la seconde piste conductrice (4, 23, 43) .

9. Dispositif de sécurité (1, 20, 40) selon la revendication 7, dans lequel le porte-fusible (2, 21, 41) présente une ouverture de passage (6, 7) sur chacun des contacts électriques (3, 22, 42, 4, 23, 43) pour chacun des fils (8, 24, 46) et une extrémité d'un fil correspondant (8, 24, 46) est guidée à travers l'ouverture de passage correspondante (6, 7) et soudée à la piste conductrice (3, 22, 42, 4, 23, 43) respective.

10. Dispositif de sécurité (1, 20, 40) selon l'une des revendications précédentes, comportant deux plaques de contact (62) qui sont appliquées sur le support (2) sur un premier côté (68) et qui sont respectivement reliées de manière électriquement conductrice à l'une des deux pistes conductrices (3, 4), dans lequel le support (2) est placé dans un boîtier (60) de manière à ce que les plaques de contact (62) fassent partiellement saillie hors du boîtier (60) et soient disposées de manière centrée par rapport à l'épaisseur (D) du boîtier (60).

11. Dispositif de sécurité (1, 20, 40) selon la revendication 10, dans lequel le boîtier (60) est constitué de deux moitiés de boîtier (66, 67), dans lequel une première moitié de boîtier (66) forme une cavité pour le fil cintré (8) et une seconde moitié de boîtier (67) forme un logement pour le support (2).

12. Dispositif de sécurité (1, 20, 40) selon l'une des revendications 10 ou 11, dans lequel les plaques de contact (62) sont coudées.

13. Dispositif de sécurité (1, 20, 40) selon l'une des revendications 10 à 12, dans lequel au moins l'une des deux plaques de contact (62) présente un trou traversant (63) qui s'engage par complémentarité de forme dans une broche (70) formée sur le boîtier (60) à des fins de décharge de traction.

14. Dispositif de sécurité (1, 20, 40) selon l'une des revendications précédentes, dans lequel des sections d'extrémité (81) des pistes conductrices (3, 4) se faisant face et l'élément de support (2) disposé en dessous présentent des évidements (80) qui entourent les extrémités longitudinales (84) respectives du conducteur fusible (8), et les extrémités longitudinales (84) du conducteur fusible (8) sont reliées par complémentarité de matériau dans la zone des évidements (80) aux sections d'extrémité (81) de la piste conductrice.

15. Dispositif de sécurité (1, 20, 40) selon la revendication 14, **caractérisé en ce que** les évidements (80) disposés sur l'élément de support (2) sont munis d'un revêtement métallique (83), auquel les extrémités longitudinales (84) du conducteur fusible (8) sont reliées par complémentarité de matériau.
